# EUROPEAN PATENT SPECIFICATION

(11) **EP 4 349 936 B1**
(45) Date of publication and mention of the grant of the patent: **11.11.2026**
(21) Application number: 22832426.5
(22) Date of filing: 22.02.2022
(51) Int. Cl.: C09K 11/61, C09K 11/80, H10H 20/851, F21S 8/00, F21S 8/08

(54) **LIGHT-EMITTING DEVICE, LIGHTING APPLIANCE, AND LIGHTING FIXTURE**
LICHTEMITTIERENDE VORRICHTUNG, BELEUCHTUNGSGERÄT UND LEUCHTE
DISPOSITIF ÉLECTROLUMINESCENT, APPAREIL D'ÉCLAIRAGE ET APPAREIL D'ÉCLAIRAGE

(30) Priority: 01.07.2021 JP 2021110054
(43) Date of publication of application: 10.04.2024
(73) Proprietor: Nichia Corporation, Anan-shi, Tokushima 774-8601 (JP)
(72) Inventor: MATSUMOTO Mika, Anan-shi, Tokushima 774-8601 (JP); KURATA Miyuki, Anan-shi, Tokushima 774-8601 (JP); FUJIO Kazushige, Anan-shi, Tokushima 774-8601 (JP)
(74) Representative: Vossius & Partner Patentanwälte Rechtsanwälte mbB
(86) International application number: PCT/JP2022/007080
(87) International publication number: WO 2023/276259

(56) References cited:
- JP-A- 2008 300 694
- JP-A- 2015 149 454
- JP-A- 2020 167 399
- JP-A- 2020 535 651
- US-A1- 2019 093 832
- US-A1- 2019 341 531

## Description

### Technical Field

The present disclosure relates to a light-emitting device, a lighting appliance, and a lighting fixture.

### Background Art

A known light-emitting device that uses light-emitting elements such as light-emitting diodes (LEDs) includes a white-light-emitting device using a blue-light-emitting element and a yellow-light-emitting phosphor or the like. Such a light-emitting device is used in a broad range of fields including general lighting, in-vehicle lighting, displays, liquid crystal backlights, and the like. With LED lighting becoming more common, interest has grown in the effects of LED lighting on the human body. For example, Patent Document 1 describes that LED lighting may affect the circadian rhythm (biorhythm) of humans.

In the retina of mammals, intrinsically photosensitive Retinal Ganglion Cells (hereinafter referred to as ipRGCs) are present that are new photoreceptors different from rods and cones. ipRGCs include the visual pigment melanopsin and are known to play a role in non-visual functions such as photic entrainment of circadian rhythms and pupil response. The control of the intrinsic photoresponse of ipRGCs is very important in forming a circadian rhythm.

Melanopsin plays a role in the secretion and suppression of melatonin, a sleep-inducing hormone, and it is thought that increasing the amount of stimulation to the ipRGCs may suppress melatonin secretion, for example. The formation of a circadian rhythm in humans can be appropriately supported by being in light appropriate for the activity time period. For example, for lighting used in the living room, bedroom, or the like, a warm and relaxing atmosphere is preferable with light being illuminated that helps promote the secretion of melatonin.

### Citation List

### Patent Literature

Patent Document 1: WO 2012/144087

In US 2019/093832 A1, a light emitting device is disclosed which includes an emission source configured to emit a primary blue light and a wavelength-converting element configured to convert the primary blue light to a secondary light having a correlated color temperature (CCT) in the range of 1600K-2500K and color rendering index (CRI) in the range of 40-60, the wavelength-converting element including a red phosphor material having a peak emission wavelength that is less than 620 nm and a green phosphor material having a peak emission wavelength that is greater than 530 nm. The device may exhibit a melanopic/photopic ratio of less than 0.25 and/or may exhibit a radiometric power fraction of light having a wavelength below 530 nm below 0.1.

### Summary

### Technical Problem

An object of an aspect of the present disclosure is to provide a light-emitting device, a lighting appliance, and a lighting fixture that emit light that tends to promote melatonin secretion.

### Solution to Problem

The invention is specified by the independent claims. Preferred embodiments are defined in the dependent claims. In the following description, although numerous features may be designated as optional, it is nevertheless acknowledged that all features comprised in the independent claims are not to be read as optional. A first aspect is a light-emitting device including a light-emitting element having an emission peak wavelength in a range of 400 nm to 490 nm; and a first phosphor having an emission peak wavelength in a range of 570 nm to 680 nm, wherein the light-emitting device emits light having a correlated color temperature that is 1950 K or less, an average color rendering index Ra that is 40 or greater, a full width at half maximum of an emission spectrum indicating a maximum emission intensity in an emission spectrum of the light-emitting device that is 110 nm or less, and a melanopic ratio MR derived from Equation (1) that is 0.233 or less.
[Equation 1] $Melanopic ratio MR = \frac{{\int }_{380}^{730} S \left(λ\right) \times {R}_{m} \left(λ\right) dλ}{{\int }_{380}^{730} S \left(λ\right) \times V \left(λ\right) dλ} \times 1.218$ (1)

Here, S(λ) is a spectral radiance of the light emitted by the light-emitting device, V(λ) is the luminous efficiency function for human photopic vision specified by the Commission Internationale de l'Eclairage (CIE), and Rₘ(λ) is a sensitivity function of the intrinsically photosensitive Retinal Ganglion Cells (ipRGC) for mammals specified by the Commission Internationale de l'Eclairage (CIE).

A second aspect is a light-emitting device including a light-emitting element having an emission peak wavelength in a range of 400 nm to 490 nm; and a first phosphor having an emission peak wavelength in a range of 570 nm to 680 nm, in which the first phosphor includes a first nitride phosphor having a composition represented by Formula (1A), and the light-emitting device emits light having a correlated color temperature that is 1950 K or less, a full width at half maximum of an emission spectrum indicating a maximum emission intensity in an emission spectrum of the light-emitting device that is 110 nm or less, and a melanopic ratio MR derived from Equation (1) that is 0.233 or less.

M¹₂Si₅N₈:Eu (1A)

Here M¹ is an alkaline earth metal element including at least one selected from the group consisting of Ca, Sr, and Ba.

A third aspect is a lighting appliance including the light-emitting device.

A fourth aspect is a lighting fixture including the light-emitting device.

### Advantageous Effects

According to an aspect of the present disclosure, a light-emitting device, a lighting appliance, and a lighting fixture that emit light that tends to promote melatonin secretion can be provided.

### Brief Description of Drawings

FIG. 1 is a diagram illustrating an ipRGC sensitivity function Rₘ(λ) and a luminous efficiency function for human photopic vision V(λ).
FIG. 2 is a CIE 1931 chromaticity diagram illustrating a black body radiation locus within the spectral locus and pure purple locus on the CIE 1931 chromaticity diagram and color deviations from the black body radiation locus.
FIG. 3 is a partially enlarged view of FIG. 2 illustrating a black body radiation locus on the CIE 1931 chromaticity diagram, in which the chromaticity coordinate x is in a range from 0.300 to 0.600 and the chromaticity coordinate y is in a range from 0.250 to 0.500, and each locus of color deviations from the black body radiation locus at each correlated color temperature.
FIG. 4 is a schematic cross-sectional view illustrating an example of a light-emitting device of a first configuration example.
FIG. 5 is a schematic cross-sectional view illustrating an example of the light-emitting device of the first configuration example.
FIG. 6 is a schematic perspective view illustrating an example of a light-emitting device of a second configuration example.
FIG. 7 is a schematic cross-sectional view illustrating an example of the light-emitting device of the second configuration example.
FIG. 8 is a schematic cross-sectional view illustrating another example of the light-emitting device of the second configuration example.
FIG. 9 is a schematic diagram illustrating an example of a street light.
FIG. 10 is a schematic diagram illustrating an example installation of a low-position lighting device, which is an example of a street light.
FIG. 11 is a diagram illustrating a reflectance spectrum of the dielectric multilayer film-1 (DBR-1), the dielectric multilayer film-2 (DBR-2), and the dielectric multilayer film-3 (DBR-3) at an angle of incidence of 0 degrees.
FIG. 12 is a schematic cross-sectional view illustrating an example of the light-emitting device of the first configuration example provided with a band-pass filter layer.
FIG. 13 is a diagram illustrating a spectral radiance of a light-emitting device of Example 1 and a light-emitting device of Comparative Example 3, an ipRGC sensitivity function Rₘ(λ), and a luminous efficiency function for human photopic vision V(λ).
FIG. 14 is a diagram illustrating a spectral radiance of a light-emitting device of Example 2 and the light-emitting device of Comparative Example 3, an ipRGC sensitivity function Rₘ(λ), and a luminous efficiency function for human photopic vision V(λ).
FIG. 15 is a diagram illustrating a spectral radiance of a light-emitting device of Example 3 and the light-emitting device of Comparative Example 3, an ipRGC sensitivity function Rₘ(λ), and a luminous efficiency function for human photopic vision V(λ).
FIG. 16 is a diagram illustrating a spectral radiance of a light-emitting device of Example 4 and the light-emitting device of Comparative Example 3, an ipRGC sensitivity function Rₘ(λ), and a luminous efficiency function for human photopic vision V(λ).
FIG. 17 is a diagram illustrating a spectral radiance of a light-emitting device of Comparative Example 1 and the light-emitting device of Comparative Example 3, an ipRGC sensitivity function Rₘ(λ), and a luminous efficiency function for human photopic vision V(λ).
FIG. 18 is a diagram illustrating a spectral radiance of a light-emitting device of Comparative Example 2 and the light-emitting device of Comparative Example 3, an ipRGC sensitivity function Rₘ(λ), and a luminous efficiency function for human photopic vision V(λ).
FIG. 19 is a diagram illustrating an emission spectrum of the light-emitting device of Example 1, an emission spectrum of a light-emitting device of Example 5 after transmission through the band-pass filter layer, and an emission spectrum of a light-emitting device of Example 6 after transmission through the band-pass filter layer.
FIG. 20 is a diagram illustrating an emission spectrum of the light-emitting device of Example 2, an emission spectrum of a light-emitting device of Example 7 after transmission through the band-pass filter layer, and an emission spectrum of a light-emitting device of Example 8 after transmission through the band-pass filter layer.
FIG. 21 is a diagram illustrating an emission spectrum of the light-emitting device of Example 3, an emission spectrum of a light-emitting device of Example 9 after transmission through the band-pass filter layer, and an emission spectrum of a light-emitting device of Example 10 after transmission through the band-pass filter layer.
FIG. 22 is a diagram illustrating an emission spectrum of the light-emitting device of Example 4, an emission spectrum of a light-emitting device of Example 11 after transmission through the band-pass filter layer, and an emission spectrum of a light-emitting device of Example 12 after transmission through the band-pass filter layer.

### Description of Embodiments

An embodiment of a light-emitting device, a lighting appliance, and a lighting fixture according to the present disclosure will be described below. However, the following embodiments of the light-emitting device, the lighting appliance, and the street light are implementations of the technical ideas of the present disclosure, and the present disclosure is not limited to the light-emitting device and the lighting appliance and street light provided with the light-emitting device described below.

Note that the relationship between the color name and the chromaticity coordinates, and the relationship between the wavelength range of light and the color name of monochromatic light, and the like conform to JIS Z 8110. Also, if a plurality of substances applicable to each component in a composition are present, the content of each component in the composition refers to the total amount of the plurality of substances present in the composition, unless otherwise specified.

A light-emitting device according to a first embodiment includes a light-emitting element having an emission peak wavelength in a range from 400 nm to 490 nm; and a first phosphor having an emission peak wavelength in a range from 570 nm to 680 nm, wherein the light-emitting device emits light that has a correlated color temperature of 1950 K or less, an average color rendering index Ra of 40 or greater, a full width at half maximum of an emission spectrum indicating a maximum emission intensity in an emission spectrum of the light-emitting device of 110 nm or less, and a melanopic ratio MR derived from Equation (1) below of 0.233 or less.
[Math. 2] $Melanopic ratio MR = \frac{{\int }_{380}^{730} S \left(λ\right) \times {R}_{m} \left(λ\right) dλ}{{\int }_{380}^{730} S \left(λ\right) \times V \left(λ\right) dλ} \times 1.218$ (1)

Here, S(λ) is a spectral radiance of light emitted by the light-emitting device, V(λ) is the luminous efficiency function for human photopic vision specified by the Commission Internationale de l'Eclairage (CIE), and Rₘ(λ) is a sensitivity function of the intrinsically photosensitive retinal ganglion cells (ipRGC) for mammals specified by the Commission Internationale de l'Eclairage (CIE).

A light-emitting device according to a second embodiment includes a light-emitting element having an emission peak wavelength in a range from 400 nm to 490 nm; and a first phosphor having an emission peak wavelength in a range from 570 nm to 680 nm, wherein the first phosphor includes a first nitride phosphor having a composition represented by later-described Formula (1A), and the light-emitting device emits light that has a correlated color temperature that is 1950 K or less, a full width at half maximum in an emission spectrum of the light-emitting device having an emission peak wavelength, at which wavelength the emission intensity is the maximum emission intensity in the emission spectrum, that is 110 nm or less, and a melanopic ratio MR derived from Equation (1) that is 0.233 or less.

Human centric lighting (HCL), an idea of lighting centered around people is starting to become more common. For example, the WELL Building Standard for certifying new buildings with a focus on the health of workers has, as a required item for certification, lighting that takes into consideration circadian rhythms. As a quantitative unit of brightness that affects the circadian rhythms, equivalent melanopic lux is used. To calculate the equivalent melanopic lux, a melanopic ratio MR obtained from the spectral distribution of the light source is required. The melanopic ratio MR is obtained from Equation (1), and the equivalent melanopic lux is obtained from Equation (2) below.
[Math. 3] $Equivalent melanopic lux = Illuminance level \times Melanopic ratio MR$ (2)

ipRGCs include the visual pigment melanopsin and are known to play a role in non-visual functions such as photic entrainment of circadian rhythms and pupil response. ipRGCs are cells that provide optical signals by direct administration to the suprachiasmatic nucleus. The suprachiasmatic nucleus is a very small region of the brain in the hypothalamus that has the function of a biological clock governing the circadian rhythms of mammals. With approximately 20000 neurons, the suprachiasmatic nucleus creates the circadian rhythm of various physiological functions such as sleep, arousal, blood pressure, body temperature, hormone secretion, and the like.

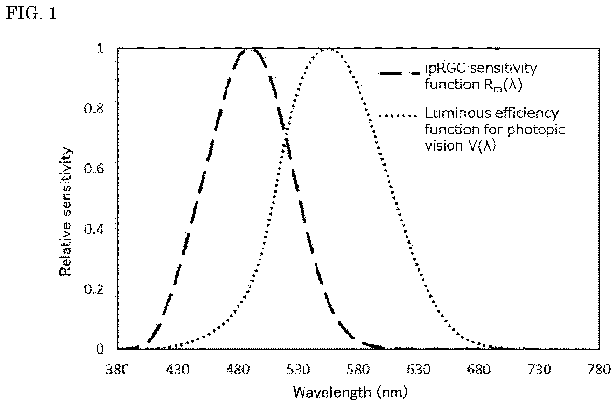

The melanopsin in the ipRGCs produces photoreceptor proteins with cells corresponding to approximately 1% or 2% of the retina ganglion cells. The other majority of the retina ganglion cells do not have photosensitivity. It is known that the photoreceptor substance has different absorption characteristics depending on the cells, and in the case of melanopsin, the maximum sensitivity (sensitivity peak wavelength) is in a range approximately from 480 nm to 490 nm. FIG. 1 is a diagram illustrating an ipRGC sensitivity function Rₘ(λ) specified by the CIE and a luminous efficiency function for human photopic vision V(λ) specified by the CIE. The maximum sensitivity (sensitivity peak wavelength) of the luminous efficiency function for human photopic vision is 555 nm.

To calculate the melanopic ratio MR, the ipRGC melanopsin response sensitivity function Rₘ(λ) is used as the circadian action curve. When light with a melanopic ratio MR derived from Equation (1) of 0.233 or less is emitted from the light-emitting device, light that has little stimulation of the ipRGCs, promotes melatonin secretion, and naturally induces sleep can be emitted. For example, the light-emitting device can be used as a light source for indoor lighting that is used in a private space such as the living room or bedroom that is expected to have a relaxing atmosphere or as a light source for in-vehicle lighting. To suppress stimulation of the ipRGCs, the light-emitting device may emit light with a melanopic ratio MR of 0.233 or less, may emit light with a melanopic ratio MR of 0.232 or less, may emit light with a melanopic ratio MR of 0.231 or less, may emit light with a melanopic ratio MR of 0.002 or greater, may emit light with a melanopic ratio MR of 0.010 or greater, may emit light with a melanopic ratio MR of 0.020 or greater, and may emit light with a melanopic ratio MR of 0.100 or greater.

Color temperature may be used as an objective measurement representing the color of light emitted from a white light source. When a black body is heated from the outside and the temperature is increased, the color changes from black, to dark red, to red, to yellow, to orange, to white, and to bluish white. The temperature of a black body can be represented in Kelvins (K), a correlated color temperature (Tcp; K) and a color deviation duv from the black body radiation locus can be measured in accordance with JIS Z8725, and an average color rendering index Ra can be measured in accordance with JIS Z8726. Typically, the color temperature is approximately 800 K for an open fire, approximately 1900 K for the flame of a candle, approximately 2900 K for the light of an incandescent lamp, and approximately 4200 K for the light of a fluorescent lamp.

The light-emitting device emits light that has a correlated color temperature of 1950 K or less, that has warmth, and that gives a relaxing atmosphere. The correlated color temperature of the light emitted by the light-emitting device may be 1920 K or less or 1900 K or less. The correlated color temperature of the light emitted from the light-emitting device is preferably 800 K or greater, preferably 1000 K or greater, may be 1200 K or greater, may be 1500 K or greater, or may be 1700 K or greater.

The color rendering property represents the degree to which an irradiated object appears at the same correlated color temperature. The average color rendering index Ra, an average value of the numerical values from R1 to R8, of the light emitted by the light-emitting device can be measured in accordance with a method for evaluating color rendering properties for light sources in JIS Z8726. The average color rendering index Ra of the light emitted by the light-emitting device is 5 or greater, may be 10 or greater, 20 or greater, 30 or greater, or 40 or greater, is preferably 51 or greater, and is more preferably 52 or greater. As the value of the average color rendering index Ra of the light emitted by the light-emitting device approaches 100, the color rendering property comes closer to that of the reference light source at the same correlated color temperature. It is sufficient that an outdoor lighting appliance such as a street light or a road light or a lighting appliance installed indoors but at a place near the outdoors emits light having an average color rendering index Ra of 5 or greater. If the average color rendering index Ra of the light emitted by the light-emitting device is 40 or greater, the color rendering property is of a degree required for a workplace where goods are sorted, and the color rendering property is sufficient for performing simple tasks in a private space such as a living room, bedroom, or the like. The average color rendering index Ra of the light emitted by light-emitting device may be 53 or greater, 99 or less, 95 or less, or 89 or less.

A special color rendering index R9 of light emitted by the light-emitting device is an index for evaluating red color. The special color rendering index R9 of the light emitted by the light-emitting device may be a negative numerical value. The special color rendering index R9 of the light emitted by the light-emitting device may be in a range of minus (-) 150 to plus (+) 99, in a range of -140 to +98, or in a range of -135 to 95.

With the light-emitting device, the full width at half maximum of the emission spectrum indicating the maximum emission intensity in the emission spectrum of the light-emitting device is 110 nm or less and may be 100 nm or less, 95 nm or less, 90 nm or less, and 3 nm or greater, 40 nm or greater, 60 nm or greater, or 70 nm or greater. In the emission spectrum of the light-emitting device, when the full width at half maximum of the emission spectrum indicating the maximum emission intensity is large, the light components on the long wavelength side which are difficult for humans to perceive are increased or the light components on the short wavelength side which tend to stimulate the ipRGCs are increased. When the light components on the long wavelength side increase, the luminance of the light emitted by the light-emitting device tends to decrease. When the light components on the short wavelength side increase, melatonin secretion is prone to be inhibited. In addition, in the emission spectrum of the light-emitting device, when the full width at half maximum of the emission spectrum indicating the maximum emission intensity is small, the light components in a specific wavelength range tend to increase. In the emission spectrum of the light-emitting device, when the emission peak wavelength having the maximum emission intensity is on the long wavelength side and the light components on the long wavelength side which are difficult for humans to perceive increase, it becomes difficult to suppress a decrease in luminance. Also, in the emission spectrum of the light-emitting device, when the emission peak having the maximum emission intensity is on the short wavelength side and the light components on the short wavelength side which tend to stimulate the ipRGCs increase, it is prone to inhibit melatonin secretion. To provide a light-emitting device emitting light that tends to promote melatonin secretion without a decrease in luminance, the light-emitting device preferably has a full width at half maximum of the emission spectrum indicating the maximum emission intensity in the emission spectrum of 110 nm or less. In the specification, the full width at half maximum refers to a wavelength width at which the emission intensity is 50% of the emission intensity at the emission peak wavelength indicating the maximum emission intensity in the emission spectrum.

In the emission spectrum of the light-emitting device, the full width at half maximum of the emission spectrum indicating the maximum emission intensity may be narrower than the full width at half maximum of the emission spectrum having the emission peak wavelength of the first phosphor or the full width at half maximum of the emission spectrum having the emission peak wavelength of a second phosphor (described below) included in the light-emitting device. For example, in a case in which the first phosphor and the second phosphor having emission peak wavelengths in wavelength ranges different from each other are included, the emission intensity changes in a region where the emission spectrum of the first phosphor and the emission spectrum of the second phosphor overlap. As a result, the emission spectrum of the mixed color light emitted by the light-emitting device is different from the emission spectrum of the first phosphor or the emission spectrum of the second phosphor, and the full width at half maximum thereof may be narrower than the full width at half maximum of the emission spectrum having the emission peak wavelength of the first phosphor or the full width at half maximum of the emission spectrum having the emission peak wavelength of the second phosphor.

In the light-emitting device, the emission peak wavelength having the maximum emission intensity in the emission spectrum of the light-emitting device is preferably in a range from 570 nm to 680 nm and may be in a range from 575 nm to 680 nm or in a range from 575 nm to 670 nm. The range of the emission peak wavelength having the maximum emission intensity in the emission spectrum of the light-emitting device may overlap with the range of the emission peak wavelength of the first phosphor. The emission peak wavelength having the maximum emission intensity in the emission spectrum of the light-emitting device may be derived from the light emission of the first phosphor.

### Light-Emitting Element

The light-emitting element has an emission peak wavelength in a range from 400 nm to 490 nm. The emission peak wavelength of the light-emitting element is preferably in a range from 420 nm to 480 nm and may be in a range from 440 nm to 460 nm. The light-emitting device emits light that has a correlated color temperature of 1950 K or less, that has warmth, and that gives a relaxing atmosphere via a mixed color light including the light emitted by the light-emitting elements and the light emitted by the first phosphor and the light emitted by the second phosphor as necessary. At least a part of the light emitted by the light-emitting element is used as excitation light for the first phosphor, and when the second phosphor is included, the light is used as excitation light for the second phosphor. In addition, a part of light emitted by the light-emitting element is used as light emitted from the light-emitting device. The full width at half maximum of the emission spectrum having an emission peak wavelength in the emission spectrum of the light-emitting element is preferably 30 nm or less, more preferably 25 nm or less, and even more preferably 20 nm or less. As the light-emitting element, for example, a semiconductor light-emitting element that uses a nitride-based semiconductor is preferably used. Accordingly, it is possible to achieve a stable light-emitting device that exhibits high efficiency and high output linearity with respect to an input and that is strong against mechanical impact.

### First Phosphor

The light-emitting device includes the first phosphor having an emission peak wavelength in a range from 570 nm to 680 nm. The first phosphor emits light having an emission peak wavelength in a range from 570 nm to 680 nm when excited by light emitted by a light-emitting element having an emission peak wavelength in a range from 400 nm to 490 nm. The first phosphor may have an emission peak wavelength in a range from 575 nm to 670 nm or may have an emission peak wavelength in a range from 580 nm to 660 nm. For the first phosphor, the full width at half maximum of the emission spectrum having an emission peak wavelength in the emission spectrum of the first phosphor is preferably in a range from 3 nm to 120 nm. The full width at half maximum of the emission spectrum having an emission peak wavelength in the emission spectrum of the first phosphor is preferably in a range from 3 nm to 15 nm or in a range from 60 nm to 120 nm. To emit light from the light-emitting device with a correlated color temperature that gives a feeling of warmth and a relaxing atmosphere, the full width at half maximum of the emission spectrum having an emission peak wavelength of the first phosphor is preferably in the range described above.

The first phosphor preferably includes at least one selected from the group consisting of a first nitride phosphor having the composition represented by Formula (1A), a second nitride phosphor having the composition represented by Formula (1B), a first fluoride phosphor represented by Formula (1C), and a second fluoride phosphor having the composition represented by Formula (1C') with a different composition to that represented by Formula (1C). The first phosphor preferably essentially includes the first nitride phosphor having the composition represented by Formula (1A). Because the light-emitting device includes the first phosphor, the light-emitting device can emit light with a correlated color temperature of 1950 K or less, a full width at half maximum of the emission spectrum indicating the maximum emission intensity in the emission spectrum of the light-emitting device of 110 nm or less, and a melanopic ratio MR of 0.233 or less.

M¹₂Si₅N₈:Eu (1A)

Here, M¹ is an alkaline earth metal element including at least one selected from the group consisting of Ca, Sr, and Ba.

Sr_{q}CaₛAlₜSiᵤNᵥ:Eu (1B)

Here, q, s, t, u, and v satisfy 0 ≤ q < 1, 0 < s ≤ 1, q + s ≤ 1, 0.9 ≤ t ≤ 1.1, 0.9 ≤ u ≤ 1.1, and 2.5 ≤ v ≤ 3.5.

A_{c}[M²_{1-b}Mn⁴⁺_{b}F_{d}] (1C)

Here, A includes at least one selected from the group consisting of K⁺, Li⁺, Na⁺, Rb⁺, Cs⁺, and NH₄⁺, and among these, K⁺ is preferable. M² includes at least one element selected from the group consisting of group 4 elements and group 14 elements, and among these, Si and Ge are preferable. b satisfies 0 < b < 0.2, c is an absolute value of electric charge of [M²_{1-b}Mn⁴⁺_{b}F_{d}] ion, d satisfies 5 < d < 7).

A'_{c}[M²'_{1-b'}Mn⁴⁺_{b'}F_{d'}] (1C')

Here, A' contains at least one selected from the group consisting of K⁺, Li⁺, Na⁺, Rb⁺, Cs⁺, and NH₄⁺, and among these, K⁺ is preferable. M^{2'} includes at least one element selected from the group consisting of group 4 elements, group 13 elements, and group 14 elements, and among these, Si and Al are preferable. b' satisfies 0 < b' < 0.2, c' is an absolute value of electric charge of [M ^{2'}_{1-b'}Mn⁴⁺_{b'}F_{d'}] ion, and d' satisfies 5 < d' < 7). In the present specification, in the formulae representing the compositions of the phosphors, the characters preceding the colon (:) represent a mole ratio for elements in one mole of composition of a host crystal and a phosphor, and the characters following the colon (:) represent an activating element.

The first phosphor preferably includes at least one selected from the group consisting of a first nitride phosphor having the composition represented by Formula (1A), a second nitride phosphor having the composition represented by Formula (1B), a first fluoride phosphor represented by Formula (1C), a second fluoride phosphor having the composition represented by Formula (1C') with a different composition to that represented by Formula (1C), a fluorogermanate phosphor having the composition represented by Formula (D), a fourth nitride phosphor having the composition represented by Formula (1E), and a first sulfide phosphor having the composition represented by Formula (1F), as described below. The first phosphor may include one type of phosphor alone or may include two or more types of phosphors.

A light-emitting device of a second embodiment includes, as the first phosphor, the first nitride phosphor having the composition represented by Formula (1A). Because the first phosphor includes the first nitride phosphor having the composition represented by Formula (1A), the light emitting device can emit light with a correlated color temperature of 1950 K or less, a full width at half maximum of the emission spectrum indicating the maximum emission intensity in the emission spectrum of the light-emitting device of 110 nm or less, and a melanopic ratio MR derived from Equation (1) of 0.233 or less. The light-emitting device according to the second embodiment preferably includes, as the first phosphor, at least one selected from the group consisting of the second nitride phosphor having the composition represented by Formula (1B) and a fluoride phosphor having the composition represented by Formula (1C).

The first phosphor may include at least one phosphor selected from the group consisting of a fluorogermanate phosphor, a fourth nitride phosphor, and a first sulfide phosphor. The fluorogermanate phosphor has a composition represented by the following Formula (1D), for example. The fourth nitride phosphor has a composition represented by the following Formula (1E), for example. The first sulfide phosphor has a composition represented by the following Formula (1F), for example.

(i - j)MgO·(j/2)Sc₂O₃·kMgF₂·mCaF₂·(1 - n)GeO₂·(n/2)M³₂O₃:Mn (1D)

Here, M³ is at least one selected from the group consisting of Al, Ga, and In. i, j, k, m, n, and z may respectively satisfy 2 ≤ i ≤ 4, 0 ≤ j ≤ 0.5, 0 < k < 1.5, 0 ≤ m < 1.5, and 0 ≤ n < 0.5.

M⁴ᵥ₂M⁵_{w2}Al_{3-y2}Si_{y2}N_{z2}:M⁶ (1E)

Here, M⁴ is at least one element selected from the group consisting of Ca, Sr, Ba, and Mg; M⁵ is at least one element selected from the group consisting of Li, Na, and K; M⁶ is at least one element selected from the group consisting of Eu, Ce, Tb, and Mn; and v2, w2, y2, and z2 respectively satisfy 0.80 ≤ v2 ≤ 1.05, 0.80 ≤ w2 ≤ 1.05, 0 ≤ y2 ≤ 0.5, and 3.0 ≤ z2 ≤ 5.0.

(Ca, Sr)S:Eu (1F)

In the present specification, a plurality of elements separated by commas (,) in a formula representing the composition of the phosphor may mean that at least one element among the plurality of elements is included in the composition and may mean that a combination of two or more among the plurality of elements is included.

The fluorogermanate phosphor having the composition represented by Formula (1D) may have a composition represented by the following Formula (1d), for example.

3.5 MgO-0.5 MgF₂•GeO₂:Mn (1d)

The fourth nitride phosphor having the composition represented by Formula (1E) may have the composition represented by the following Formula (1e).

m⁴ᵥ₂M⁵_{w2}M⁶ₓ₂Al_{3-y2}Si_{y2}N_{z2} (1e)

Here, M⁴, M⁵, and M⁶ respectively have the same meanings as M⁴, M⁵, and M⁶ in Formula (1E), v2, w2, y2, and z2 have respectively the same meanings as v2, w2, y2, and z2 in Formula (1E), and x2 satisfies 0.001 < x2 ≤ 0.1.

The fluorogermanate phosphor, the fourth nitride phosphor, and the first sulfide phosphor have emission peak wavelengths in a range from 570 nm to 680 nm and preferably have emission peak wavelengths in a range from 600 nm to 630 nm. The fluorogermanate phosphor, the fourth nitride phosphor, and the first sulfide phosphor each have a full width at half maximum of the emission spectrum having an emission peak wavelength in the emission spectrum of the first phosphor in a range from 5 nm to 100 nm and preferably in a range from 6 nm to 90 nm.

The light-emitting device of the first embodiment and the light-emitting device of the second embodiment may include one type of the first phosphor alone or may include two or more types of the first phosphor. Because the light-emitting device includes the first phosphor, the light-emitting device emits light with a correlated color temperature that gives a feeling of warmth and a relaxing atmosphere.

In a case in which the first nitride phosphor having the composition represented by Formula (1A) is essentially included as the first phosphor, all of the first phosphor may be the first nitride phosphor. In a case in which, as the first phosphor, the first nitride phosphor having the composition represented by Formula (1A) is essentially included and a first phosphor other than the first nitride phosphor having the composition represented by Formula (1A) is included, the mass ratio (first nitride phosphor/first phosphor other than the first nitride phosphor) between the first nitride phosphor and the first phosphor other than the first nitride phosphor blended in the first phosphor may be in a range from 99/1 to 1/99, a range from 98/2 to 10/90, or a range from 95/5 to 30/70. The first phosphor, which is other than the first nitride phosphor and has the composition represented by Formula (1A), corresponds to at least one phosphor selected from the group consisting of the second nitride phosphor having the composition represented by Formula (1B), the first fluoride phosphor represented by Formula (1C), the second fluoride phosphor represented by Formula (1C'), the fluorogermanate phosphor having the composition represented by Formula (1D), the fourth nitride phosphor having the composition represented by Formula (1E), and the first sulfide phosphor represented by Formula (1F).

The light-emitting device of the first embodiment or the light-emitting device of the second embodiment may include, as the first phosphor, at least one selected from the group consisting of the fluorogermanate phosphor having the composition represented by Formula (1D), the fourth nitride phosphor having the composition represented by Formula (1E), and the first sulfide phosphor having the composition represented by Formula (1F). The first phosphor may include one type of phosphor alone or may include two or more types of phosphors.

The content of the first phosphor included in the light-emitting device varies depending on the form and the like of the light-emitting device. In a case in which the first phosphor is included in a wavelength conversion member of the light-emitting device, the wavelength conversion member preferably includes phosphors and a light transmissive material. The wavelength conversion member may include a wavelength conversion body including phosphors and a light transmissive material. The total amount of the phosphors included in the wavelength conversion member may be 10 parts by mass or greater, 15 parts by mass or greater, 20 parts by mass or greater, 30 parts by mass or greater, 40 parts by mass or greater, or 50 parts by mass or greater relative to 100 parts by mass of the light transmissive material. Also, the total amount may be 900 parts by mass or less, 800 parts by mass or less, 700 parts by mass or less, 600 parts by mass or less, 500 parts by mass or less, or 400 parts by mass or less. The total amount of the phosphors refers to the total amount of the first phosphor in a case in which the light-emitting device includes only the first phosphor and does not include a phosphor other than the first phosphor. The total amount of the phosphors refers to the total amount of the first phosphor and the second phosphor in a case in which the light-emitting device includes the first phosphor and the second phosphor.

In a case in which the light-emitting device includes the second phosphor described below, the content of the first phosphor included in the light-emitting device is preferably in a range from 5 mass% to 95 mass% with respect to the total amount of the first phosphor and the second phosphor. When the content of the first phosphor included in the light-emitting device is in a range from 5 mass% to 95 mass% with respect to the total amount of the first phosphor and the second phosphor, the light-emitting device can emit light having a correlated color temperature of 1950 K or less, a full width at half maximum of the emission spectrum indicating the maximum emission intensity in the emission spectrum of the light-emitting device of 110 nm or less, and a melanopic ratio MR of 0.233 or less, giving the light a correlated color temperature that gives a feeling of warmth and a relaxing atmosphere. The content of the first phosphor included in the light-emitting device may be in a range from 8 mass% to 80 mass%, a range from 10 mass% to 70 mass%, or a range from 11 mass% to 60 mass% with respect to the total amount of the first phosphor and the second phosphor.

### Second Phosphor

The light-emitting device preferably includes the second phosphor having an emission peak wavelength in a range from 480 nm to less than 570 nm. The second phosphor preferably has an emission peak wavelength in a range from 480 nm to 569 nm. The second phosphor emits light having an emission peak wavelength in a range from 480 nm to less than 570 nm when excited by light emitted by a light-emitting element having an emission peak wavelength in a range from 400 nm to 490 nm. The second phosphor, when excited by the light-emitting element, may have an emission peak wavelength in a range from 490 nm to 565 nm or may have an emission peak wavelength in a range from 495 nm to 560 nm. The second phosphor has a full width at half maximum of the emission spectrum having an emission peak wavelength in the emission spectrum of the second phosphor preferably in a range from 20 nm to 125 nm, and the full width at half maximum may be in a range from 25 nm to 124 nm or in a range from 30 nm to 123 nm. To emit light with a correlated color temperature that gives a feeling of warmth and a relaxing atmosphere, the full width at half maximum of the emission spectrum having an emission peak wavelength in the emission spectrum of the second phosphor is preferably in a range from 20 nm to 125 nm.

The second phosphor preferably includes at least one selected from the group consisting of a rare earth aluminate phosphor having the composition represented by Formula (2A) and a third nitride phosphor having the composition represented by Formula (2B).

Ln'₃(Al₁₋ₐGaₐ)₅O₁₂:Ce (2A)

Here, Ln¹ is at least one element selected from the group consisting of Y, Gd, Tb, and Lu, and a satisfies 0 ≤ a ≤ 0.5.

La_{w}Ln²ₓSi₆N_{y}:Ce_{z} (2B)

Here, Ln² essentially includes at least one selected from the group consisting of Y and Gd and may include at least one selected from the group consisting of Sc and Lu, and assuming the Ln² element included in 1 mol of the composition is 100 mol%, the total of Y and Gd included in Ln² is 90 mol% or greater, and w, x, y, and z satisfy 1.2 ≤ w ≤ 2.2, 0.5 ≤ x ≤ 1.2, 10 ≤ y ≤ 12.0, 0.5 ≤ z ≤ 1.2, 1.80 < w + x < 2.40, and 2.9 ≤ w + x + z ≤ 3.1.

In the rare earth aluminate phosphor having the composition represented by Formula (2A) and the third nitride phosphor having the composition represented by Formula (2B), the full width at half maximum of the emission peak having an emission peak wavelength in the emission spectrum of the phosphor is, for example, 90 nm or greater, preferably 100 nm or greater, and more preferably 110 nm or greater and, for example, 125 nm or less, preferably 124 nm or less, and more preferably 123 nm or less.

The second phosphor may include at least one phosphor selected from the group consisting of an alkaline earth metal aluminate phosphor and an alkaline earth metal halosilicate phosphor. The alkaline earth metal aluminate phosphor is, for example, a phosphor including at least strontium and activated with europium and has a composition represented by, for example, the following Formula (2C). Also, the alkaline earth metal halosilicate phosphor is, for example, a phosphor including at least calcium and chlorine and activated with europium and has a composition represented by, for example, the following Formula (2D).

Sr₄Al₁₄O₂₅:Eu (2C)

(Ca,Sr,Ba)₈MgSi₄O₁₆(F,Cl,Br)₂:Eu (2D)

Here, Sr may be partially substituted with at least one element selected from the group consisting of Mg, Ca, Ba, and Zn.

The alkaline earth metal aluminate phosphor having the composition represented by Formula (2C) and the alkaline earth metal halosilicate phosphor having the composition represented by Formula (2D) have emission peak wavelengths in a range from 480 nm to less than 520 nm and preferably have emission peak wavelengths in a range from 485 nm to 515 nm.

In the alkaline earth metal aluminate phosphor having the composition represented by Formula (2C) and the alkaline earth metal halosilicate phosphor having the composition represented by Formula (2D), the full width at half maximum of the emission peak having an emission peak wavelength in the emission spectrum of the phosphor is, for example, 30 nm or greater, preferably 40 nm or greater, and more preferably 50 nm or greater and, for example, 80 nm or less and preferably 70 nm or less.

The second phosphor may include at least one phosphor selected from the group consisting of a β-SiAlON phosphor, a second sulfide phosphor, a scandium-based phosphor, and an alkaline earth metal silicate-based phosphor. The β-SiAlON phosphor has a composition represented by the following Formula (2E), for example. The second sulfide phosphor has the composition represented by the following Formula (2F), for example. The scandium-based phosphor has a composition represented by the following Formula (2G), for example. The alkaline earth metal silicate-based phosphor has, for example, the composition represented by the following Formula (2H) or the composition represented by the following Formula (2I).

Si_{6-g}Al_{g}O_{g}N_{8-g}:Eu(0 < g ≤ 4.2) (2E)

(Sr,M⁷)Ga₂S₄:Eu (2F)

Here, M⁷ is at least one element selected from the group consisting of Be, Mg, Ca, Ba, and Zn.

(Ca,Sr)Sc₂O₄:Ce (2G)

(Ca,Sr)₃(Sc,Mg)₂Si₃O₁₂:Ce (2H)

(Ca,Sr,Ba)₂SiO₄:Eu (2I)

The β-SiAlON phosphor, the second sulfide phosphor, the scandium-based phosphor, and the alkaline earth metal silicate-based phosphor have emission peak wavelengths in a range from 520 nm to less than 580 nm and preferably have emission peak wavelengths in a range from 525 nm to 565 nm. In the β-SiAlON phosphor, the second sulfide phosphor, the scandium-based phosphor, and the alkaline earth metal silicate-based phosphor, the full width at half maximum of the emission spectrum having an emission peak wavelength in the emission spectrum of the second phosphor is, for example, 20 nm or greater and preferably 30 nm or greater and, for example, 120 nm or less and preferably 115 nm or less.

The second phosphor may include at least one phosphor selected from the group consisting of the rare earth aluminate phosphor having the composition represented by Formula (2A), the third nitride phosphor having the composition represented by Formula (2B), the alkaline earth metal aluminate phosphor having the composition represented by Formula (2C), the alkaline earth metal halosilicate phosphor having the composition represented by Formula (2D), the β-SiAlON phosphor having the composition represented by Formula (2E), the second sulfide phosphor having the composition represented by Formula (2F), the scandium-based phosphor having the composition represented by Formula (2G), the alkaline earth metal silicate-based phosphor having the composition represented by Formula (2H), and the alkaline earth metal silicate-based phosphor having the composition represented by Formula (2I). The second phosphor may include one type of phosphor alone or may include two or more types.

The light-emitting device preferably emits light having a color deviation Duv, which is a deviation from a black body radiation locus, preferably in a range from minus (-) 0.008 to plus (+) 0.008. The color deviation Duv is a deviation from the black body radiation locus of light emitted from the light-emitting device and is measured according to JIS Z8725. Even in the case of a relatively low correlated color temperature of 1950 K or less, when the color deviation Duv from the black body radiation locus (Duv: 0.000) on the CIE 1931 chromaticity diagram is in a range from - 0.008 to +0.008, light emitted from the light-emitting device allows irradiated objects to have a natural color and causes less discomfort to humans. The light-emitting device emits light having the color deviation Duv, which is a deviation from the black body radiation locus, at 1950 K or less, preferably in a range from -0.008 to +0.008, more preferably in a range from -0.006 to +0.006, and even more preferably in a range from -0.003 to +0.003. When emitted light having the color deviation Duv, which is a deviation from the black body radiation locus, at 1950 K or less, is greater than 0.008, the color of irradiated objects deviates from the natural color, which may cause discomfort to humans.

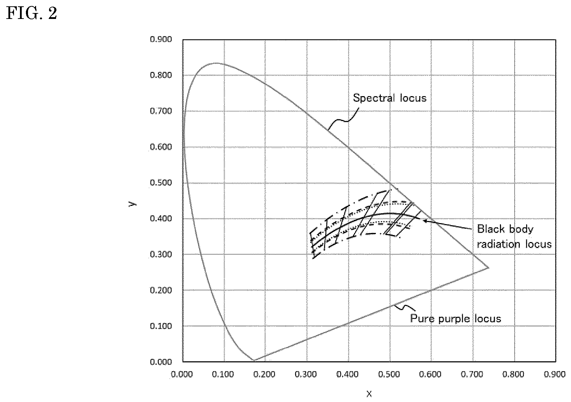

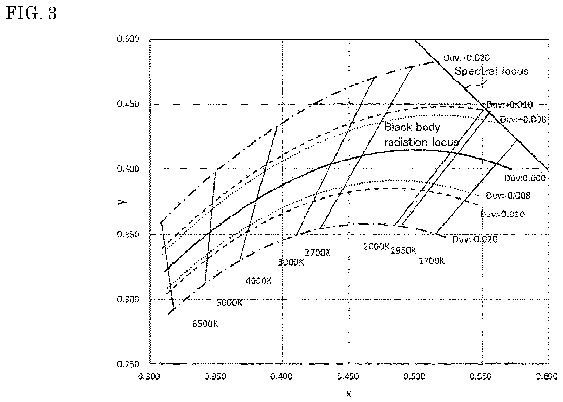

FIG. 2 is a diagram illustrating a black body radiation locus (Duv: 0.000) in the spectral locus and pure purple locus on the CIE 1931 chromaticity diagram and color deviations from the black body radiation locus. FIG. 3 is a partially enlarged view of FIG. 2 illustrating a black body radiation locus on the CIE 1931 chromaticity diagram in which the chromaticity coordinate x is in a range from 0.300 to 0.600 and the chromaticity coordinate y is in a range from 0.250 to 0.500, and each locus of color deviations from the black body radiation locus at each correlated color temperature with Duv of -0.020, Duv of -0.010, Duv of -0.008, Duv of +0.008, Duv of +0.010, and Duv of +0.020. As illustrated in FIGS. 2 and 3, the straight lines intersecting with the black body radiation locus (Duv: 0.000) are each an isotemperature line at each correlated color temperature (CCT of 1700 K, 1950 K, 2000 K, 2700 K, 3000 K, 4000 K, 5000 K, and 6500 K). In a case in which the color deviation Duv of the mixed color light emitted from the light-emitting device is 0, the locus thereof has no deviation from the black body radiation locus and is approximately the black body radiation locus.

The light-emitting device preferably emits light having a second radiance in a range from 650 nm to 750 nm being 50% or less with respect to 100% of a first radiance in a range from 400 nm to 750 nm. In the light emitted by the light-emitting device, the ratio of the second radiance in a range from 650 nm to 750 nm with respect to 100% of the first radiance in a range from 400 nm to 750 nm is also referred to as Lp. When the ratio Lp of the second radiance to the first radiance in the light emitted by light-emitting device is 50% or less, among the mixed color light emitted from the light-emitting device, there is a relatively small amount of light with red color components on the long wavelength side which are difficult for humans to perceive. Thus, the light emitted from the light-emitting device has warmth and gives a relaxing atmosphere without reduced luminance. The ratio Lp of the second radiance to the first radiance of the light emitted by light-emitting device may be 45% or less, 40% or less, 35% or less, or 30% or less. The ratio Lp of the second radiance to the first radiance of the light emitted by the light-emitting device may be 5% or greater or 8% or greater in order to emit light having good color rendering property.

The ratio Lp of the second radiance to the first radiance of the light emitted by the light-emitting device is derived from the following Equation (3). In the light emitted by the light-emitting device, a ratio Lp of the second radiance in a range from 650 nm to 750 nm with respect to 100% of the first radiance in a range from 400 nm to 750 nm is the proportion of light with a long wavelength red color component in the mixed color light emitted by the light-emitting device.
[Math. 4] $Lp \left(%\right) = \frac{{\int }_{650}^{750} S \left(λ\right) dλ}{{\int }_{400}^{750} S \left(λ\right) dλ} \times 100$ (3)

The light-emitting device preferably emits light having a relative melanopic ratio MR/MR₀ of 99% or less. The relative melanopic ratio MR/MR₀ refers to a ratio of the melanopic ratio MR derived from Equation (1) of the light-emitting device emitting light having a correlated color temperature of 1950 K or less assuming a reference melanopic ratio MR₀ of the light-emitting device emitting light having a correlated color temperature of greater than 1950 K is 100%. Regarding the reference melanopic ratio MR₀, a melanopic ratio MR having the lowest numerical value among the light-emitting devices to be measured that emit light having a correlated color temperature of greater than 1950 K can be used as the reference melanopic ratio MR₀. When the relative melanopic ratio MR/MR₀ is low, less than 99%, the light-emitting device can emit light that promotes melatonin secretion and that naturally induces sleep. When light having a relative melanopic ratio MR/MR₀ of less than 10% is emitted from a light-emitting device, for example, when light having a relative melanopic ratio MR/MR₀ of 9% or less is emitted from a light-emitting device, the melatonin secretion effect is greater than that of a light-emitting device that emits light having a correlated color temperature of greater than 1950 K, but the color balance of light is lost and the color rendering property is reduced. For example, the light-emitting device preferably emits light with a relative melanopic ratio MR/MR₀ in a range from 10% to 99%, so that the light emitted satisfies the color rendering property expected for the light-emitting device and has warmth and gives the feeling of a relaxing atmosphere, even when used in a private space such as a living room, bedroom, or the like. The light-emitting device that emits light having a correlated color temperature of 1950 K or less may have a relative melanopic ratio MR/MR₀ in a range from 10% to 99%, in a range from 30% to 98%, or in a range from 40% to 96%.

The reference melanopic ratio MR₀ of a light-emitting device that emits light having a correlated color temperature of greater than 1950 K can be derived from the following Equation (4).
[Math. 5] $Melanopic ratio {MR}_{0} = \frac{{\int }_{380}^{730} {S}_{0} \left(λ\right) \times {R}_{m} \left(λ\right) dλ}{{\int }_{380}^{730} {S}_{0} \left(λ\right) \times V \left(λ\right) dλ} \times 1.218$ (4)

Here, MR₀ is a melanopic ratio of a light-emitting device having a correlated color temperature of greater than 1950 K, S₀(λ) is a spectral radiance of light emitted by the light-emitting device having a correlated color temperature of greater than 1950 K, and V(λ) and Rₘ(λ) have the same meanings as in Equation (1).

The relative melanopic ratio MR/MR₀ (%) can be derived from the following Equation (5).
[Math. 6] $MR / {MR}_{0} \left(%\right) = \frac{{\int }_{380}^{730} S \left(λ\right) \times {R}_{m} \left(λ\right) dλ / {\int }_{380}^{780} S \left(λ\right) \times V \left(λ\right) dλ}{{\int }_{380}^{730} {S}_{0} \left(λ\right) \times {R}_{m} \left(λ\right) dλ / {\int }_{380}^{780} {S}_{0} \left(λ\right) \times V \left(λ\right) dλ} \times 100$ (5)

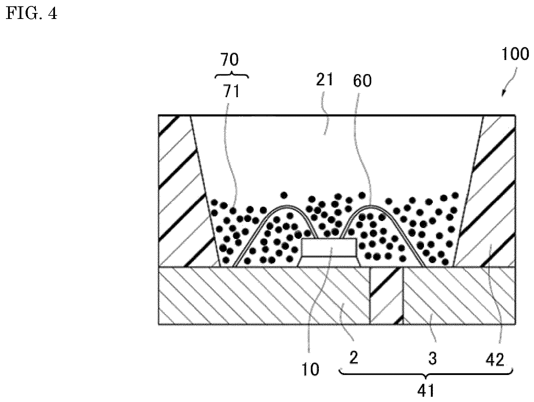

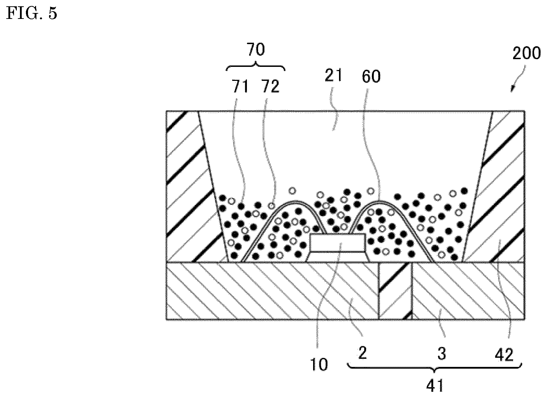

An example of the light-emitting device will be described on the basis of the drawings. FIGS. 4 and 5 are schematic cross-sectional views illustrating a light-emitting device of a first configuration example.

As illustrated in FIG. 4, a light-emitting device 100 includes a light-emitting element 10 having an emission peak wavelength in a range from 400 nm to 490 nm and a first phosphor 71 that emits light when excited by light from the light-emitting element.

The light-emitting device 100 includes a molded body 41, the light-emitting element 10, and a wavelength conversion member 21. The molded body 40 is formed by integrally molding a first lead 2, a second lead 3, and a resin portion 42 including a thermoplastic resin or a thermosetting resin. The molded body 41 forms a recessed portion having a bottom surface and lateral surfaces, and the light-emitting element 10 is mounted on the bottom surface of the recessed portion. The light-emitting element 10 includes a pair of positive and negative electrodes, and the pair of positive and negative electrodes are respectively electrically connected to the first lead 2 and the second lead 3 via wires 60. The light-emitting element 10 is covered with the wavelength conversion member 21. The wavelength conversion member 21 includes, for example, a light transmissive material and phosphors 70 that convert the wavelength of the light from the light-emitting element 10. The wavelength conversion member 21 also functions as an encapsulation member that covers the light-emitting element 10 and the phosphors 70 in the recessed portion of the molded body 40. The phosphors 70 include the first phosphor 71 having an emission peak wavelength in a range from 570 nm to 680 nm when excited by light from the light-emitting element. The first lead 2 and the second lead 3 connected to the pair of positive and negative electrodes of the light-emitting element 10 are partially exposed to the outside of a package forming the light-emitting device 100. The light-emitting device 100 can emit light by receiving power supplied from an external source via the first lead 2 and the second lead 3.

As illustrated in FIG. 5, a light-emitting device 200 is the same as the light-emitting device 100 illustrated in FIG. 4 except that the phosphors 70 further include a second phosphor 72 having an emission peak wavelength in a range from 480 nm to 570 nm, and like members are denoted by similar reference numerals.

A wavelength conversion member in a light-emitting device of the first configuration example includes phosphors and a light transmissive material, and the light transmissive material is preferably a resin. Examples of the light transmissive material used for the wavelength conversion member include at least one selected from the group consisting of a resin, glass, and an inorganic material. The resin is preferably at least one selected from the group consisting of an epoxy resin, a silicone resin, a phenol resin, and a polyimide resin. The inorganic material may be at least one selected from the group consisting of aluminum oxide and aluminum nitride. The wavelength conversion member may include, in addition to the phosphors and the light transmissive material, a filler, a coloring agent, and a light diffusing material as necessary. Examples of the filler include silicon dioxide, barium titanate, titanium oxide, and aluminum oxide. The content of the components other than the phosphors and the light transmissive material included in the wavelength conversion member can be in a range from 0.01 parts by mass to 50 parts by mass, and may be in a range from 0.1 parts by mass to 45 parts by mass, or in a range from 0.5 parts by mass to 40 parts by mass relative with respect to 100 parts by mass of the light transmissive material, in terms of the total content of the other components.

### Method for Manufacturing Light-Emitting Device of First Configuration Example

A method for manufacturing the light-emitting device of the first configuration example will now be described. For the details, the disclosure of Japanese patent Publication No. 2010-62272 may be referred to, for example. The method for manufacturing a light-emitting device preferably includes providing a molded body, disposing a light-emitting element, disposing a composition for a wavelength conversion member, and forming a resin package. In a case in which a collective molded body including a plurality of recessed portions is used as the molded body, singulating may be included after forming the resin package to separate the resin package into respective unit regions.

In providing the molded body, a plurality of leads are integrally molded using a thermosetting resin or a thermoplastic resin to provide a molded body including a recessed portion having lateral surfaces and a bottom surface. The molded body may be formed from a collective base including a plurality of recessed portions.

In disposing the light-emitting element, the light-emitting element is disposed on the bottom surface of the recessed portion of the molded body, and the positive and negative electrodes of the light-emitting element are connected to the first lead and the second lead via wires.

In disposing the composition for a wavelength conversion member, the composition for a wavelength conversion member is disposed in the recessed portion of the molded body.

In forming the resin package, the composition for a wavelength conversion member disposed in the recessed portion of the molded body is cured to form a resin package, and thus a light-emitting device is manufactured. In a case in which a molded body formed from a collective base including a plurality of recessed portions is used, after forming the resin package, in the singulation, the collective base including a plurality of recessed portions is separated into the individual resin packages each as the unit region, and individual light-emitting devices are manufactured. In this manner, the light-emitting device of the first configuration example illustrated in FIG. 4 or 5 can be manufactured.

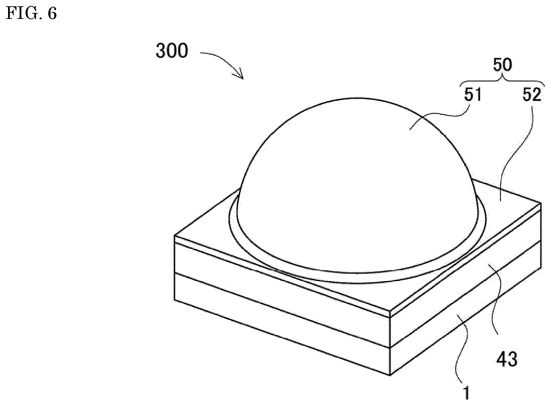

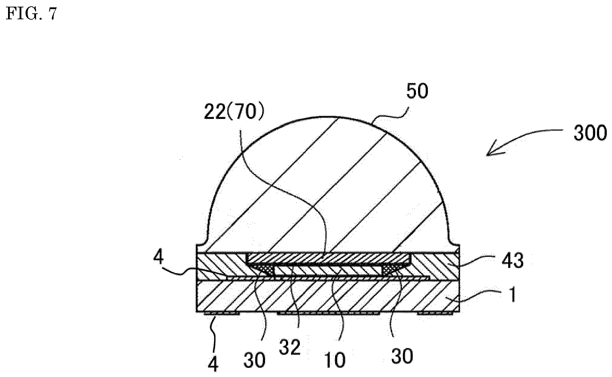

FIG. 6 is a schematic perspective view illustrating a light-emitting device of a second configuration example. FIG. 7 is a schematic cross-sectional view illustrating the light-emitting device of the second configuration example.

As illustrated in FIGS. 6 and 7, a light-emitting device 300 includes a support 1, the light-emitting element 10 disposed on the support 1, a wavelength conversion member 22 including the phosphors 70 disposed on the upper surface of the light-emitting element 10, and a light reflecting member 43 disposed on the support 1 while being at the lateral side of the wavelength conversion member 22 and the light-emitting element 10. An encapsulation member 50 is provided on the upper surface of the wavelength conversion member 22. The encapsulation member 50 includes a lens portion 51 having a circular shape in a plan view and a semi-spherical shape in a cross-sectional view and a flange portion 52 extending to the outer peripheral side of the lens portion 51. The lens portion 51 has a circular shape in a plan view and a semi-spherical shape in a cross-sectional view. Also, the flange portion 52 extends to the outer peripheral side of the lens portion 51.

The wavelength conversion member 22 is formed larger than the light-emitting element 10 in a plan view. In addition, a first light transmissive member 30 that comes into contact with the lateral surface of the light-emitting element 10 and a portion of the wavelength conversion member 22 is provided between the lateral surface of the light-emitting element 10 and the light reflecting member 43. The first light transmissive member 30 includes a light transmissive bonding member 32 provided between the light-emitting element 10 and the wavelength conversion member 22. The light transmissive bonding member 32 may be an adhesive that bonds together the light-emitting element 10 and the wavelength conversion member 22. A portion of the light transmissive bonding member 32 may extend to a corner portion formed by the lateral surface of the light-emitting element 10 and the main surface of the wavelength conversion member 22 on the light-emitting element 10 side. As illustrated in FIG. 7, the cross-sectional shape of the extended light transmissive bonding member 32 can be an inverted triangle expanding in the direction toward the light reflecting member 43. The first light transmissive member 30 and the bonding member 32 can be formed of a resin with light transmissivity. The support 1 is a member for mounting the light-emitting element 10, the encapsulation member 50, and the like on the upper surface thereof. The support 1 includes a base material with insulating properties and a conductive member 4 such as a wiring pattern for mounting a light-emitting element on the surface of the base material. The light reflecting member 43 is a member for covering the first light transmissive member 30, the bonding member 32, and the wavelength conversion member 22. For the details of the light-emitting device of the second configuration example and the method for manufacturing the light-emitting device of the second configuration example described below, the disclosure of Japanese Patent Publication No. 2020-57756 can be referred to, for example.

As with the wavelength conversion member of the light-emitting device of the first configuration example, the wavelength conversion member of the light-emitting device of the second configuration example may be a single phosphor-layer including phosphor(s) and a light transmissive material. The phosphor(s) include a first phosphor having an emission peak wavelength in a range from 570 nm to 680 nm when excited by light from the light-emitting element. The phosphor(s) may include a second phosphor having an emission peak wavelength in a range from 480 nm to 570 nm when excited by light from the light-emitting element. As the light transmissive material, the same light transmissive material as that used in the wavelength conversion member of the light-emitting device of the first configuration example can be used. In addition to the phosphor(s) and the light transmissive material, the wavelength conversion member of the light-emitting device of the second configuration example may include a filler, a coloring agent, and a light diffusing material as necessary as with the wavelength conversion member of the light-emitting device of the first configuration example. When the wavelength conversion member is a single phosphor-layer including phosphor(s) and a light transmissive material, a composition for a phosphor layer including phosphor(s) and a light transmissive material is cured to form a plate-like, sheet-like, or layer-like shape in advance and then singulated at a size that allows it to be disposed on the light-emitting element to form a plate-like, sheet-like, or layer-like wavelength conversion member.

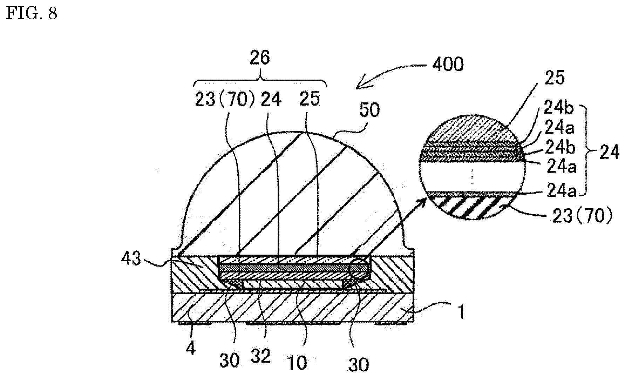

FIG. 8 is a schematic cross-sectional view illustrating the light-emitting device of another example of the second configuration example and a partially enlarged view of the schematic cross-sectional view of a phosphor layer, a band-pass filter layer, and a second light-transmissive member. The light-emitting device in FIG. 8 is different from the light-emitting device illustrated in FIG. 7 in that, a wavelength conversion member including a phosphor layer including phosphor(s), a band-pass filter layer, and a second light-transmissive member is used, but is the same as or similar to the light-emitting device illustrated in FIG. 7 in terms of the other members of the light-emitting device.

The light-emitting device includes, on the light emission side of the light-emitting elements, a wavelength conversion member including a phosphor layer including a first phosphor and a band-pass filter layer disposed on the light emission side of the phosphor layer. Also, the band-pass filter layer preferably has an average reflectivity of light with a wavelength range from 380 nm to less than 495 nm, for example, light with a wavelength range from 380 nm to 494 nm, of 80% or greater, and has an average reflectivity of light with a wavelength range from greater than 580 nm to 780 nm, for example, light with a wavelength range from 581 nm to 780 nm, of 20% or less, with respect to light with an angle of incidence in a range from 0 degrees to 30 degrees. Because the light-emitting device includes the wavelength conversion member including the band-pass filter layer described above, light components on the short wavelength side that tend to inhibit melatonin secretion are suppressed, and the melanopic ratio MR can be decreased. The band-pass filter layer more preferably has an average reflectivity of light with a wavelength range from 380 nm to less than 495 nm of 80% or greater, and has an average reflectivity of light with a wavelength range from greater than 525 nm to 780 nm of 20% or less, with respect to light with an angle of incidence in a range from 0 degrees to 30 degrees. The band-pass filter layer even more preferably has an average reflectivity of light with a wavelength range from 380 nm to less than 495 nm of 80% or greater, and has an average reflectivity of light with a wavelength range from greater than 500 nm to 780 nm of 20% or less, with respect to light with an angle of incidence in a range from 0 degrees to 30 degrees.

The proportion of a spectral radiance Sₐ(λ) of the light emission in a specific wavelength range of the light-emitting device after the dielectric multilayer film, that is, the band-pass filter layer, is disposed with respect to a spectral radiance S_{b}(λ) in a specific wavelength range of the light-emitting device before the dielectric multilayer film, that is, the band-pass filter layer, is disposed being 100%, can be measured as the retention ratio of the spectral components of the light-emitting device including the band-pass filter layer. An example of the specific wavelength range includes a range from 300 nm to 800 nm, for example. The retention ratio of the spectral components in a range from 300 nm to 800 nm of the light-emitting device including the band-pass filter layer can be calculated using the following Equation (6). The retention ratio of the spectral components in a range from 300 nm to 800 nm of the light-emitting device including the band-pass filter layer is preferably 40% or greater, more preferably 50% or greater, even more preferably 60% or greater, yet even more preferably 70% or greater, and particularly preferably 80% or greater. When the retention ratio of the spectral components of the light-emitting device including the band-pass filter layer is less than 40%, for example, when the retention ratio of the spectral components of the light-emitting device including the band-pass filter layer is 39% or less, a portion of the light of the emission spectrum of the color of the light emitted from the light-emitting device may be weakened and there is a possibility of the color of the emitted light causing discomfort in humans. Also, when the retention ratio of the spectral components of the light-emitting device including the band-pass filter layer is less than 40%, a large amount of light is reflected at the band-pass filter layer and there is a possibility that the component of light wavelength-converted by the phosphors is reduced and the luminance is reduced. The retention ratio of the spectral components of the light-emitting device including the band-pass filter layer may be 100% or less, 95% or less, 92% or less, or 91% or less.
[Math. 7] $\begin{matrix}Spectral component \\ retention ratio \left(%\right)\end{matrix} = \frac{{\int }_{300}^{800} {S}_{a} \left(λ\right) dλ}{{\int }_{300}^{800} {S}_{b} \left(λ\right) dλ} \times 100$ (6)

A light-emitting device 400 includes a wavelength conversion member 26 including a phosphor layer 23 including the phosphors 70 and a band-pass filter layer 24. The wavelength conversion member 26 may include a second light-transmissive member 25 and may be a multilayer body including the phosphor layer 23, the band-pass filter layer 24, and the second light-transmissive member 25 layered in this order from the light emission side of the light-emitting elements. The phosphors 70 included in the phosphor layer 23 include the first phosphor and may include the second phosphor. The phosphor layer 23, the band-pass filter layer 24, and the second light-transmissive member 25 may be formed in a plate-like, sheet-like, or layer-like shape larger than the light-emitting element 10 in a plan view, and the phosphor layer 23, the band-pass filter layer 24, and the second light-transmissive member 25 are layered in this order from the side of the light-emitting element 10 to form the wavelength conversion member 26.

The band-pass filter layer 24 is preferably formed from a dielectric multilayer film. The dielectric multilayer film can be constituted by a multilayer film including, for example, a first dielectric layer 24a and a second dielectric layer 24b with mutually different refractive indices alternately layered. By setting the emission spectrum of the light emitted by the light-emitting element 10 (central wavelength and intensity distribution to the wavelength) and the film thickness of the first dielectric layer 24a and the film thickness of the second dielectric layer 24b on the basis of a first refractive index of the first dielectric layer 24a and a second refractive index of the second dielectric layer 24b, the band-pass filter layer 24 can be formed so that, for light in an angle of incidence in a range from 0 degrees to 30 degrees, light in a wavelength range of from 380 nm to less than 495 nm is reflected and light with an emission peak wavelength in a range of from 570 nm to 680 nm emitted by the phosphors included in the phosphor layer 23 is transmitted. The band-pass filter layer 24 formed of a dielectric multilayer film includes two types of the first dielectric layer 24a and the second dielectric layer 24b with different refractive indices formed alternating in cycles at a film thickness of λ/4. λ is the peak wavelength of the wavelength region to be reflected and is the wavelength in the medium of each dielectric material. For the band-pass filter layer 24, the refractive indices, the difference in refractive indices, and the number of alternately formed cycles of the first dielectric layer 24a formed of a dielectric material with a low refractive index and the second dielectric layer 24b formed of a dielectric material with a high refractive index are set as appropriate to stably obtain the desired average reflectivity in the desired wavelength range.

The refractive index (first refractive index) of the first dielectric layer with a low refractive index can be set in a range from 1.0 to 1.8, for example, and can be preferably set in a range from 1.2 to 1.6. The first dielectric layer, for example, can be formed of SiO₂ (with a refractive index of 1.5, for example). The refractive index (second refractive index) of the second dielectric layer with a high refractive index can be set in a range from 1.5 to 3.0, for example, and can be preferably set in a range from 2.0 to 2.6. The second dielectric layer, for example, can be formed of Nb₂O₅ (with a refractive index of 2.4, for example). The number of cycles alternately formed by the first dielectric layer and the second dielectric layer can be set in a range from 1 to 30, for example, and can be preferably set in a range from 1 to 25.

The dielectric material forming the first dielectric layer can be selected from SiO₂, Al₂O₃, and SiON, for example. The dielectric material forming the second dielectric layer can be selected from TiO₂, Nb₂O₃, Ta₂O₅, and Zr₂O₅, for example.

For the phosphor layer, a wavelength conversion member formed of a single phosphor-layer, or a similar phosphor layer can be used. For the light-transmissive member, a member formed of glass or resin can be used. The glass can be selected from borosilicate glass or quartz glass, for example. Also, the resin can be selected from silicone resin and epoxy resin, for example.

The wavelength conversion member including the phosphor layer, the band-pass filter layer, and the second light-transmissive member can be formed as follows, for example. To begin with, a plate-like second light-transmissive member is provided. Subsequently, a band-pass filter layer formed of a dielectric multilayer film including a first dielectric layer and a second dielectric layer with mutually different refractive indices alternately layered is formed. The dielectric multilayer film can be formed by alternately depositing the first dielectric layer and the second dielectric layer via Atomic Layer Deposition (ALD), sputtering, vapor deposition, or the like. Subsequently, a phosphor layer is formed on the band-pass filter layer. The phosphor layer can be formed on the band-pass filter layer using a printing method, for example. In the printing method, a composition for a phosphor layer including phosphors, a binder, and a solvent as necessary is provided and the composition for a phosphor layer is applied to the surface of the band-pass filter layer formed of a dielectric multilayer film and dried to form a phosphor layer. For the binder, an organic binder such as an epoxy resin, a silicone resin, a phenol resin, or a polyimide resin and an inorganic binder such as glass can be used. The phosphor layer can be formed by a compression molding method, a phosphor electrodeposition method, a phosphor sheet method, or the like instead of the printing method.

### Method for Manufacturing Light-Emitting Device of Second Configuration Example

An example of a method for manufacturing the light-emitting device of the second configuration example will now be described. The method for manufacturing the light-emitting device of the second configuration example includes disposing the light-emitting element, providing the wavelength conversion member, forming the light transmissive member and the bonding member, disposing the light reflecting member, and disposing the encapsulation member, and may further include singulating for separating into unit regions.

In disposing the light-emitting element, the light-emitting element is flip-chip mounted on a support provided in advance. In providing the wavelength conversion member, a plate-like, sheet-like, or layer-like wavelength conversion member formed in advance via the method described above is singulated at a size that allows it to be disposed on the light-emitting element to provide a plate-like, sheet-like, or layer-like wavelength conversion member. In forming the first light transmissive member and the bonding member, an adhesive with light transmissivity is applied onto the upper surface of the light-emitting element, and the wavelength conversion member is bonded to the upper surface of the light-emitting element. The adhesive protruding from the interface between the light-emitting element and the wavelength conversion member extends and adheres from the lateral surface of the light-emitting element to the periphery of the wavelength conversion member, forms a fillet shape, and is cured to form the first light transmissive member and the bonding member. In disposing the light reflecting member, a white resin is disposed and cured on the upper surface of the support so as to cover the lateral surfaces of the wavelength conversion member and the light transmissive member, thus disposing the light reflecting member. After these steps, the encapsulation member is disposed on the upper surfaces of the wavelength conversion member and the light reflecting member. In this manner, the light-emitting device of the second configuration example can be manufactured.

### Lighting Appliance or Lighting Fixture

It is sufficient that the lighting appliance or lighting fixture includes at least one of the light-emitting devices described above. The lighting appliance or lighting fixture includes the above-described light-emitting device and may further include a reflecting member, a protective member, an accessory device for supplying power to the light-emitting device, and the like. The lighting appliance or lighting fixture may also include a plurality of light-emitting devices. In a case in which the lighting appliance or lighting fixture includes a plurality of light-emitting devices, the lighting appliance or lighting fixture may include a plurality of the same light-emitting devices or a plurality of light-emitting devices having different forms. In addition, a drive device that can individually drive the plurality of light-emitting devices and adjust the brightness or the like of each light-emitting device may be provided. The lighting appliance or lighting fixture may be any of a direct attaching-type, an embedding-type, a pendant-type, or the like. The lighting appliance may be a street light, a lighting appliance expected to be installed outdoors at a harbor or in a tunnel, may be a lighting appliance such as a headlight, flashlight, or portable lantern using LEDs expected to be used outdoors, or may be a lighting appliance installed indoors but at a place near the outdoors such as by a window. The lighting fixture can emit light from the light-emitting device described above with a color that gives warmth and a feeling of a relaxing atmosphere, promotes melatonin secretion, and naturally induces sleep and may be used as general lighting used indoors in a private space such as an indoor living room or bedroom, indirect lighting, or in-vehicle lighting.

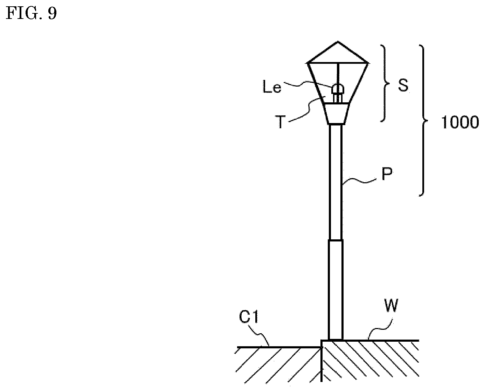

It is sufficient that the street light includes at least one of the light-emitting devices described above. FIG. 9 is a schematic diagram illustrating an example of a street light 1000. The street light 1000 includes a pole P installed on a sidewalk W or a roadway C1 and a support portion S of a light-emitting device Le, and the support portion S includes a light transmitting portion T which covers the periphery of the light-emitting device Le and transmits at least part of the light emitted by the light-emitting device Le, the light transmitting portion T being formed of acrylic, polycarbonate, glass, or the like. The street light 1000 can illuminate a low place from a high place via the light-emitting device Le installed on the support portion S integrated with the pole P. The street light may be a pole-type street light provided with a pole that allows the height of the support portion to be set discretionarily, may be a bracket-type street light in which the support portion is supported with a bracket instead of a pole, may be a floodlight-type street light that illuminates upward from below, and may be a landscape material-embedded-type street light that is incorporated into a landscape material such as a pillar or a block.

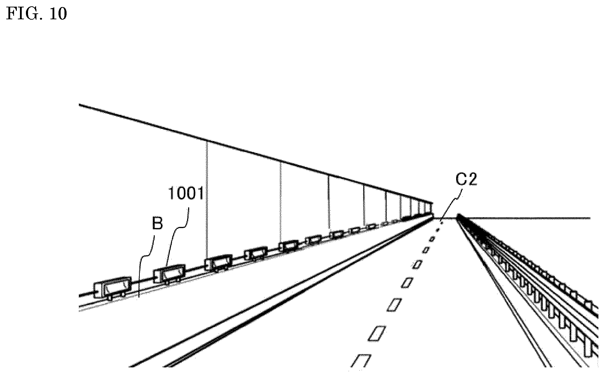

The street light may be a low-position lighting device that illuminates the road surface from a low position. It is sufficient that the low-position lighting device includes at least one of the light-emitting devices described above. By using the light-emitting device described above as a low-position lighting device, light with a relaxing warmth can be emitted. FIG. 10 is a schematic diagram illustrating an example of a low-position lighting device 1001. The low-position lighting device 1001 may be installed on a placement platform B provided on a side portion of a road C2, for example. The low-position lighting device can be installed at a position lower than the eye level of drivers in vehicles driving on the roadway, for example. The low-position lighting device may be installed at a height in a range from approximately 1 m to 1.2 m from the road surface of the roadway. The low-position lighting device may be installed on the side portion of a flower bed or a sidewalk of park instead of on the side portion of the road.

### Examples

The present disclosure will be described in detail hereinafter using examples. However, the present disclosure is not limited to these examples.

In the light-emitting devices of the examples and the comparative examples, the following first phosphor and/or second phosphor was used.

### First Phosphor

As the first phosphor, first nitride phosphors BSESN-2 and BSESN-3 included in the composition represented by Formula (1A), second nitride phosphors SCASN-1, SCASN-2, SCASN-3, SCASN-4, and SCASN-6 included in the composition represented by Formula (1B), and fluoride phosphor KSF included in the composition represented by Formula (1C) were provided. These phosphors are the first nitride phosphor or the second nitride phosphor included in the composition represented by Formula (1A) or Formula (1B), but each molar ratio of the elements included in each composition is different and each emission peak wavelength and each full width at half maximum are different, as illustrated in Table 1.

### Second Phosphor

As the second phosphor, rare earth aluminate phosphors G-YAG1 and G-YAG4 included in the composition represented by Formula (2A) with the composition Y₃(Al,Ga)₅O₁₂:Ce (a satisfies 0 < a ≤ 0.5) and rare earth aluminate phosphors YAG1 and YAG3 included in the composition represented by Formula (2A) with the composition Y₃Al₅O₁₂:Ce were provided. These phosphors are the rare earth aluminate phosphors included in the composition represented by Formula (2A), but the molar ratio of the elements included in each composition is different and each emission peak wavelength and each full width at half maximum are different, as illustrated in Table 2.

### Measurement of Emission Spectrum of Phosphor

Using a quantum efficiency measurement device (QE-2000 manufactured by Otsuka Electronics Co., Ltd.), each phosphor was irradiated with light having an excitation wavelength of 450 nm, the emission spectrum at room temperature (approximately 25°C) was measured, and the emission peak wavelength and the full width at half maximum were measured from the emission spectrum. The results are listed in Tables 1 and 2.

**[Table 1]**

| | Peak wavelength(nm) | Half band width(nm) |
|---|---|---|
| SCASN1 | 608 | 73.5 |
| SCASN2 | 612 | 74.6 |
| SCASN3 | 620 | 72.9 |
| SCASN4 | 628 | 75.4 |
| SCASN6 | 642 | 96.4 |
| BSESN2 | 586 | 74.2 |
| BSESN3 | 594 | 80.6 |
| KSF | 631 | 7.2 |

**[Table 2]**

| | Peak wavelength(nm) | Half band width(nm) |
|---|---|---|
| G-YAG1 | 539 | 108.8 |
| G-YAG4 | 557 | 111.7 |
| YAG1 | 548 | 111.2 |
| YAG3 | 565 | 118.9 |

### Band-pass Filter Layer

A band-pass filter layer including the dielectric multilayer film-1 (DBR-1), the dielectric multilayer film-2 (DBR-2), and the dielectric multilayer film-3 (DBR-3) used in the Examples can be used.

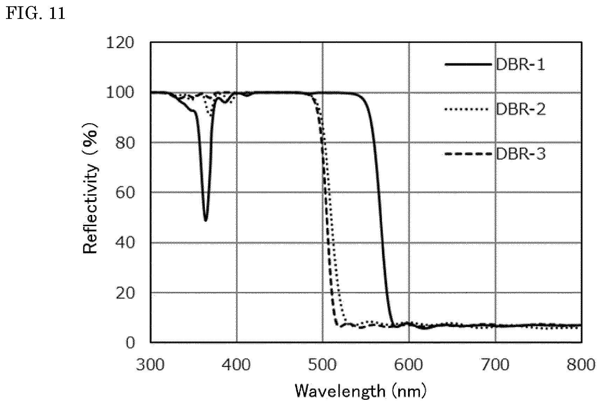

Measurement of Reflectance Spectrum of Dielectric Multilayer Film For each of the dielectric multilayer films, light was irradiated by an excitation light source from a normal direction (0-degree angle of incidence) of the dielectric multilayer film and a spectrophotometer (V-670, available from JASCO corporation) was used to measure the reflectance spectrum in a wavelength range from 300 nm to 800 nm at room temperature (25°C ± 5°C). The reflectance spectra of the dielectric multilayer film-1 (DBR-1), the dielectric multilayer film-2 (DBR-2), and the dielectric multilayer film-3 (DBR-3) were measured. The reflectance spectra of the dielectric multilayer film-1 (DBR-1), the dielectric multilayer film-2 (DBR-2), and the dielectric multilayer film-3 (DBR-3) are illustrated in FIG. 11. In the reflectance spectra of the dielectric layers with an angle of incidence of 0 degrees, the maximum reflection intensity in a wavelength range from 380 nm to 780 nm is set to 100%. With respect to light with an angle of incidence of 0 degrees, the average reflectivity of light in a wavelength range from 380 nm to less than 495 nm, the average reflectivity of light in a wavelength range from greater than 580 nm to 780 nm, the average reflectivity of light in a wavelength range from 525 nm to 780 nm, and the average reflectivity of light in a wavelength range from 500 nm to 780 nm are listed in Table 3.

**[Table 3]**

| | Average reflectivity (%) | | | |
|---|---|---|---|---|
| | From 380nm to less than 495nm | From 500nm to 780nm | From 525nm to 780nm | From greater than 580nm to 780nm |
| DBR-1 | 99.4 | 28.8 | 21.8 | 6.8 |
| DBR-2 | 99.3 | 10.6 | 7.1 | 6.9 |
| DBR-3 | 99.6 | 8.7 | 6.8 | 6.8 |

For the dielectric multilayer film-1 (DBR-1), the average reflectivity of light in a wavelength range from 380 nm to less than 495 nm was 80% or greater, and the average reflectivity of light in a wavelength range from greater than 580 nm to 780 nm was 20% or less. For the dielectric multilayer film-1 (DBR-1), the dielectric multilayer film-2 (DBR-2), and the dielectric multilayer film-3 (DBR-3), the light in a wavelength range from 380 nm to less than 495 nm is light in a wavelength range from 380 nm to 494 nm, for example. Also, the light in a wavelength range from greater than 580 nm to 780 nm is light in a wavelength range from 581 nm to 780 nm, for example.

For the dielectric multilayer film-2 (DBR-2), the average reflectivity of light in a wavelength range from 380 nm to less than 495 nm was 80% or greater, and the average reflectivity of light in a wavelength range from 525 nm to 780 nm was 20% or less. For the dielectric multilayer film-3 (DBR-3), the average reflectivity of light in a wavelength range from 380 nm to less than 495 nm was 80% or greater, and the average reflectivity of light in a wavelength range from 500 nm to 780 nm was 20% or less.

### Examples 1 and 2

The light-emitting device of the first configuration example was manufactured. FIG. 5 can be referred to for the light-emitting device of the first configuration example.

The light-emitting element 10 used included nitride-based semiconductor layers with an emission peak wavelength of 450 nm. The size of the light-emitting element 10 corresponds to a roughly square planar shape of approximately 700 mm square and a thickness of approximately 200 mm.

A lead frame was used as the first lead 2 and the second lead 3, and the first lead 2 and the second lead 3 were integrally molded using an epoxy resin to provide the molded body 41 including the recessed portion with the lateral surfaces and the bottom surface. The light-emitting element 10 was disposed on the bottom surface of the recessed portion of the molded body 41, and the positive and negative electrodes of the light-emitting element 10 were connected to the first lead 2 and the second lead 3 via the wires 60 formed of Au.

A silicone resin was used as the light transmissive material forming the wavelength conversion member 21. The first phosphor 71 and the second phosphor were blended as the composition for a wavelength conversion member so that a correlated color temperature of a mixed color light, in which light emitted from the light-emitting element 10 and light emitted from the phosphors 70 including the first phosphor 71 and the second phosphor 72 are mixed, was in a range from 1800K to 1850 K or near this range, which is 1950 K or less. The total amount of the phosphors 70 relative to 100 parts by mass of the light transmissive material and the blending ratio for the first phosphors 71 and the second phosphor 72 are as listed in Table 4. In the composition for a wavelength conversion member, 2 parts by mass of the aluminum oxide was also blended as a filler relative to 100 parts by mass of the silicone resin. Subsequently, the provided composition for a wavelength conversion member was supplied into the recessed portion of the molded body 41.

The composition for a wavelength conversion member supplied into the recessed portion of the molded body 41 was heated at 150°C for 3 hours and cured to form a resin package including the wavelength conversion member 21 including the first phosphor 71 and the second phosphor 72. Thus, the light-emitting device 200 of the first configuration example that emits light having a correlated color temperature of 1950 K or less was manufactured.

### Example 3

The light-emitting device of the first configuration example was manufactured. The light-emitting device of the first configuration example includes only the first phosphor but not the second phosphor as illustrated in FIG. 4.

The resin package was formed and the light-emitting device 100 of the first configuration example that emits light having a correlated color temperature of 1950 K or less was manufactured in the same manner as in Example 1, except that the first phosphor 71 was 100 mass% of the total amount of the phosphors 70 (total amount of the first phosphor 71) and the total amount of the first phosphor 71 and the second phosphor using the first phosphor 71 listed for each example in Table 4 as the composition for a wavelength conversion member. As listed in Table 4, as the first phosphor, two different types of the first nitride phosphor, BSESN2 and BSESN3, having the composition represented by Formula (1A) were used, and the mass ratio (BSESN2/BSESN3) of BSESN2 and BSESN3 was 30/70.

### Example 4

The light-emitting device 200 of the first configuration example was manufactured. The light-emitting device 200 of the first configuration example includes the first phosphor 71 and the second phosphor 72 as illustrated in FIG. 5.

A phenyl silicone resin was used as the light transmissive material forming the wavelength conversion member 21. The phosphors listed in Table 4 were used as the first phosphor 71 and the second phosphor 72.

The first phosphor 71 and the second phosphor were blended as the composition for a wavelength conversion member relative to 100 parts by mass of the light transmissive material as shown in FIG. 4 so that a correlated color temperature of a mixed color light of light emitted from the light-emitting element 10 and light emitted from the phosphors 70 including the first phosphor 71 was in a range from 1800K to 1850 K or near this range, which is 1950 K or less. In the composition for a wavelength conversion member, 15 parts by mass of the silicon dioxide was blended as a filler relative to 100 parts by mass of the phenyl silicone resin. Subsequently, the provided composition for a wavelength conversion member was supplied into the recessed portion of the molded body 41.

The composition for a wavelength conversion member supplied into the recessed portion of the molded body 41 was heated at 150°C for 4 hours and cured to form a resin package including the wavelength conversion member 21 including the first phosphor 71 and the second phosphor 72. Thus, the light-emitting device 200 of the first configuration example that emits light having a correlated color temperature of 1950 K or less was manufactured.

### Examples 5 and 6

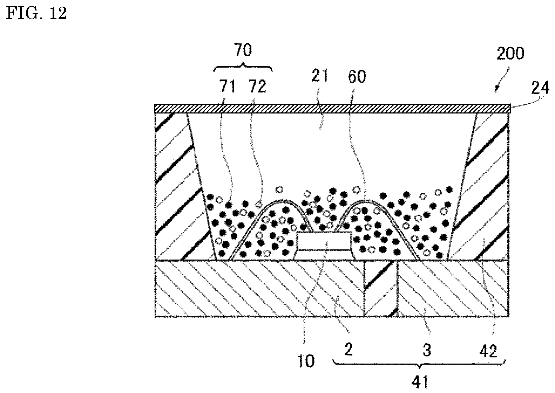

The light-emitting device of the first configuration example is manufactured as in Example 1, and the dielectric multilayer film is disposed as the band-pass filter layer 24 on the light emission side of the wavelength conversion member 21 of the light-emitting device 100 as illustrated in FIG. 12. In Example 5, a dielectric multilayer film 2 (DBR-2) is disposed on the light emission side of the wavelength conversion member of the light-emitting device as in Example 1. In Example 6, a dielectric multilayer film 3 (DBR-3) is disposed on the light emission side of the wavelength conversion member of the light-emitting device as in Example 1.

### Examples 7 and 8

In Example 7, the dielectric multilayer film 2 (DBR-2) is disposed on the light emission side of the wavelength conversion member of the light-emitting device as in Example 2. In Example 8, the dielectric multilayer film 3 (DBR-3) is disposed on the light emission side of the wavelength conversion member of the light-emitting device as in Example 2.

### Examples 9 and 10

In Example 9, the dielectric multilayer film 2 (DBR-2) is disposed on the light emission side of the wavelength conversion member of the light-emitting device as in Example 3. In Example 10, the dielectric multilayer film 3 (DBR-3) is disposed on the light emission side of the wavelength conversion member of the light-emitting device as in Example 3.

### Examples 11 and 12

In Example 11, the dielectric multilayer film 2 (DBR-2) is disposed on the light emission side of the wavelength conversion member of the light-emitting device as in Example 4. In Example 12, the dielectric multilayer film 3 (DBR-3) is disposed on the light emission side of the wavelength conversion member of the light-emitting device as in Example 4.

### Comparative Example 1

The light-emitting device of the second configuration example was manufactured.

FIGS. 6 and 7 can be referred to for the light-emitting device of the second configuration example.

### Disposing of Light-emitting Element

A ceramic substrate including aluminum nitride as a material was used as the support 1. The light-emitting element 10 used included nitride-based semiconductor layers with an emission peak wavelength of 450 nm. The size of the light-emitting element 10 corresponds to a roughly square planar shape of approximately 1.0 mm square and a thickness of approximately 0.11 mm. The light-emitting element was disposed with the light emission surface on the encapsulation member side and flip-chip mounted via a bump using the conductive member 4 formed of Au.

### Providing of Wavelength Conversion Member

A silicone resin was used as the light transmissive material forming the wavelength conversion member 22. The first phosphor 71 and the second phosphor were blended as the composition for a wavelength conversion member relative to 100 parts by mass of the light transmissive material so that a correlated color temperature of a mixed color light, in which light emitted from the light-emitting element 10 and light emitted from the phosphors 70 including the first phosphor 71 and the second phosphor were mixed, was at or near 2230K that is a color temperature close to that of a sodium lamp. The total amount of the phosphors 70 relative to 100 parts by mass of the light transmissive material and the blending ratio for the first phosphors and the second phosphor are as listed in Table 4. In the composition for a wavelength conversion member, 2 parts by mass of the aluminum oxide was blended as a filler relative to 100 parts by mass of the silicone resin. Subsequently, the provided composition for a wavelength conversion member was heated at 180°C for 2 hours and cured into a sheet-like shape. Then, the singulated sheet-like wavelength conversion member 22 was provided having a roughly square planar shape of approximately 1.6 mm square and a thickness of approximately 150 µm, which is approximately 0.1 mm larger in length and width than the planar shape of the light-emitting element 10.

### Forming of Light Transmissive Member and Bonding Member

A phenyl silicone resin, which is an adhesive with light transmissivity, was applied onto the upper surface of the light-emitting element 10 to bond the wavelength conversion member 22 thereon, the adhesive with light transmissivity was further applied to the interface between the light-emitting element 10 and the wavelength conversion member 22, and then cured at 150°C for 4 hours to form the first light transmissive member 30 and the bonding member 32, which were cured in a fillet shape extending from the lateral surface of the light-emitting element 10 to the periphery of the wavelength conversion member 22.

### Disposing of Light Reflecting Member

A composition for a light reflecting member including a dimethyl silicone resin and titanium oxide particles having an average particle size (catalog value) of 0.28 µm in which the amount of the titanium oxide particles is 60 parts by mass relative to 100 parts by mass of the dimethyl silicone resin was provided. The composition for a light reflecting member, which is a white resin, was disposed on the upper surface of the support 1 to cover the lateral surfaces of the wavelength conversion member 22 and the light transmissive member 30 and then cured to form the light reflecting member 43.

### Disposing of Encapsulation Member

After these steps, the encapsulation member 50 formed by curing phenyl silicone resin and including the lens portion 51 having a circular shape in a plan view and a semi-spherical shape in a cross-sectional view and the flange portion 52 extending to the outer peripheral side of the lens portion 51 was disposed to manufacture the light-emitting device 300 of the second configuration example that emits light having a correlated color temperature of greater than 1950 K.

### Comparative Examples 2 and 3

The light-emitting device of the first configuration example was manufactured. The light-emitting device of the first configuration example includes the first phosphor and the second phosphor.

As the composition for a wavelength conversion member, a composition for a wavelength conversion member was provided including the first phosphor 71 and the second phosphor 72 relative to 100 parts by mass of phenyl silicone resin as a light transmissive material so that a correlated color temperature of a mixed color light, in which light emitted from the light-emitting element 10 and light emitted from the phosphors 70 including the first phosphor 71 and the second phosphor 72 were mixed, was at or near 2000 K that is a color temperature close to that of a sodium lamp. In the composition for a wavelength conversion member, the total amount of the phosphors 70 relative to 100 parts by mass of the light transmissive material and the blending ratio of the first phosphor 71 and the second phosphor 72 are as listed in Table 4.

The composition for a wavelength conversion member was placed onto the light-emitting element 10 in the recessed portion of the molded body 41, supplied into the recessed portion, and heated at 150°C for 4 hours to cure the composition for a phosphor member and form a phosphor member 21. Thus, the light-emitting device 200 of the first configuration example that emits light having a correlated color temperature in a range from greater than 1950 K to 2000 K was manufactured.

The following measurements were performed for the light-emitting devices. The results are listed in Tables 4 to 7.

### Emission Spectrum of Light-emitting Device

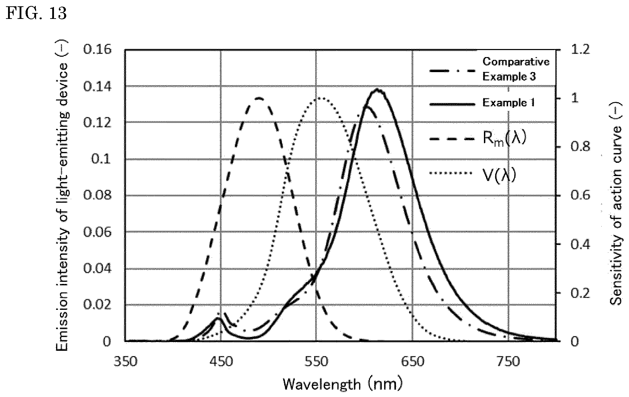

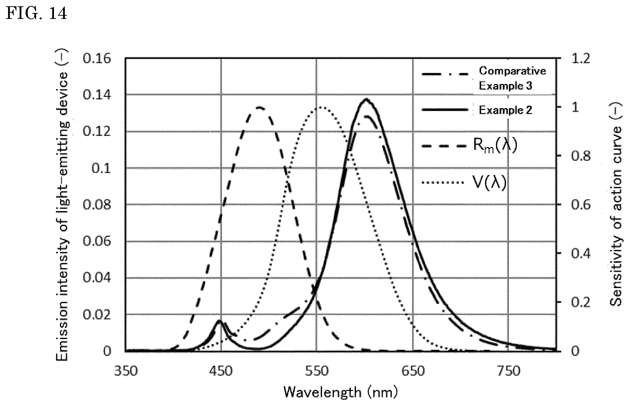

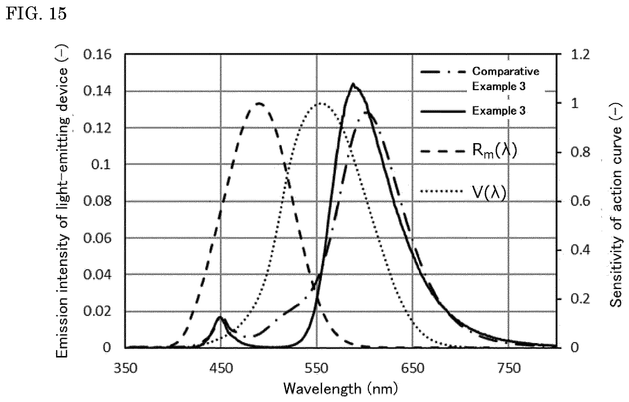

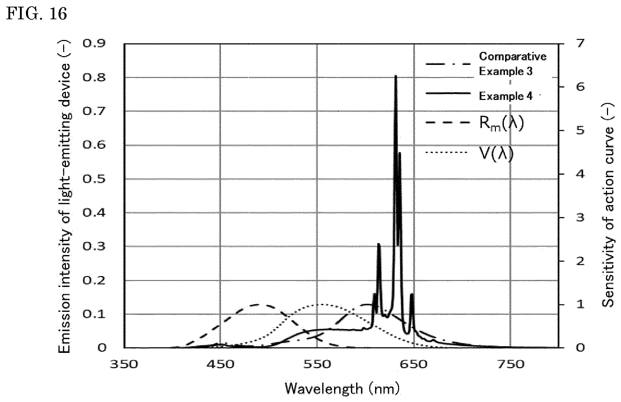

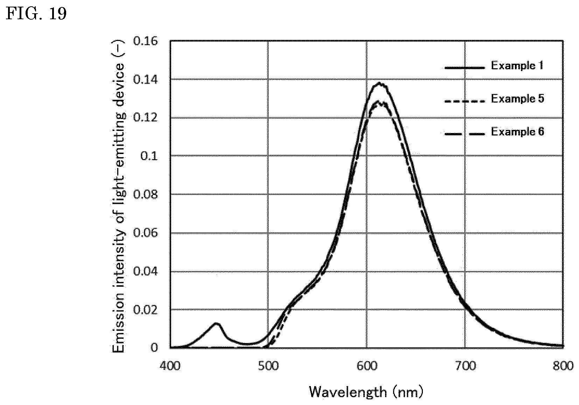

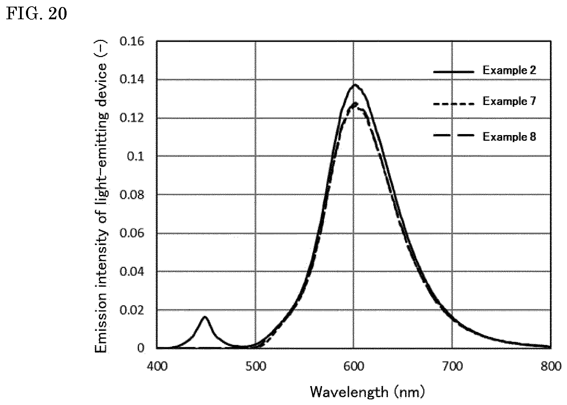

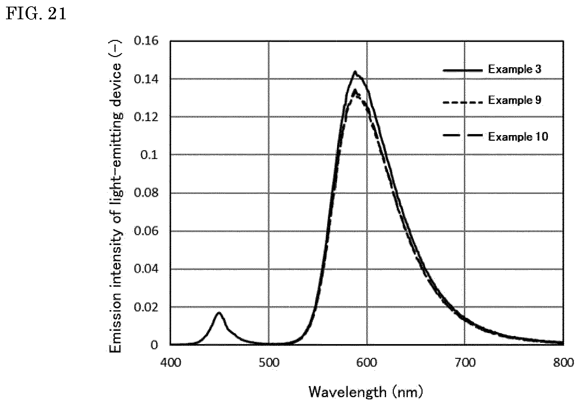

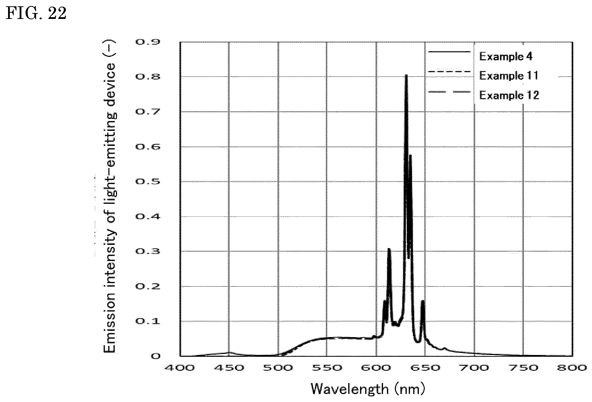

For each light-emitting device, the emission spectrum was measured using an optical measurement system combining a spectrophotometer (PMA-12, Hamamatsu Photonics K.K.) and an integrating sphere. The emission spectrum of each light-emitting device was measured at room temperature (in a range from 20°C to 30°C). FIGS. 13 to 18 illustrate the emission spectrum (spectral radiance) S(λ) of each light-emitting device when the luminance derived from the denominator in Formula (1) of each light-emitting device is set to the same value, the luminous efficiency function for human photopic vision V(λ) specified by the CIE, and the ipRGC sensitivity function Rₘ(λ) specified by the CIE. FIGS. 19 to 22 illustrate the emission spectrum of a light-emitting device without a band-pass filter layer and each light-emitting device with a band-pass filter layer.

Chromaticity Coordinates (x, y), Correlated Color Temperature (K), Color Deviation Duv, Average Color Rendering Index Ra, Special Color Rendering Index R9, and Full Width at Half Maximum

From the emission spectrum of each light-emitting device, the chromaticity coordinates (x value, y value) on the CIE chromaticity diagram of CIE 1931, the correlated color temperature (CCT:K) and color deviation Duv according to JIS Z8725, the average color rendering index Ra according to JIS Z8726, the special color rendering index R9, and the full width at half maximum were measured.

### Ratio Lp of Second Radiance to First Radiance

From the emission spectrum (spectral radiance) S(λ) of each light-emitting device, the ratio Lp (%) of the second radiance in a range from 650 nm to 750 nm was calculated on the basis of Equation (3) assuming the first radiance in a range from 400 nm to 750 nm was 100%.

### Melanopic Ratio MR

The emission spectrum (spectral radiance) S(λ) measured for each light-emitting device, the luminous efficiency function for human photopic vision V(λ) specified by the CIE, and the ipRGC sensitivity function Rₘ(λ) specified by the CIE were substituted into Equation (1) and the melanopic ratio MR of each light-emitting device was measured on the basis of Equation (1). For the luminous efficiency function for human photopic vision V(λ), an action curve with the maximum sensitivity (sensitivity peak wavelength) set to 1 was used. For the ipRGC sensitivity function Rₘ(λ) specified by the CIE, an action curve with the maximum sensitivity (sensitivity peak wavelength) set to 1 was used.

### Relative Melanopic Ratio MR/MR₀

The melanopic ratio MR of the light-emitting device of Comparative Example 3, which had the lowest numerical value for the melanopic ratio MR among the light-emitting devices of Comparative Examples 1 to 3 that emit light having a correlated color temperature of greater than 1950 K, was set as the reference melanopic ratio MR₀ on the basis of Equation (4). The relative melanopic ratio MR/MR₀, which is the ratio of the melanopic ratio MR of each light-emitting device to the reference melanopic ratio MR₀ was calculated on the basis of Equation (5).

### Spectral Component Retention Ratio when Band-pass Filter Layer is Provided

The proportion of the spectral radiance Sₐ(λ) of the light emission in a wavelength range from 300 nm to 800 nm of the light-emitting device after the dielectric multilayer film (i.e., the band-pass filter layer) is disposed with respect to the spectral radiance S_{b}(λ) of the light emission in a wavelength range from 300 nm to 800 nm of the light-emitting device before the dielectric multilayer film (i.e., the band-pass filter layer) is disposed being 100%, can be calculated as the retention ratio (%) of the spectral components when a band-pass filter layer is provided on the basis of Equation (6).

**[Table 4]**

| | Phosphor | | | | | Correlated color temperature CCT (K) | Color deviation Duv | Average color rendering index Ra | Full width at half maximum (nm) of emission peak having maximum emission intensity | Melanopic ratio MR | Relative Melanopic Ratio MR/MR₀ (%) |
|---|---|---|---|---|---|---|---|---|---|---|---|
| | First phosphor | Second phosphor | Phosphor total amount (parts by mass) | Blending ratio (mass%) | | | | | | | |
| | | | | First phosphor | Second phosphor | | | | | | |
| Example 1 | SCASN4 | G-YAG4 | 123.6 | 12.1 | 87.9 | 1809 | 0.000 | 73 | 87 | 0.194 | 83 |
| Exanple 2 | SCASN1 | YAG3 | 104.3 | 53.3 | 46.7 | 1803 | 0.000 | 51 | 80 | 0.145 | 62 |
| Example 3 | BSESN2 /BSESN3 = 30/70 | - | 75.0 | 100.0 | - | 1819 | 0.000 | 30 | 72 | 0.103 | 44 |
| Example 4 | KSF | YAG3 | 82.1 | 86.5 | 13.5 | 1819 | 0.000 | 88 | 4 | 0.227 | 97 |
| Comparative Example 1 | SCASN3 | YAG1 | 170.0 | 17.0 | 83.0 | 2231 | -0.002 | 70 | 95 | 0.291 | 125 |
| Comparative Example 2 | SCASN6 | G-YAG1 | 120.0 | 16.3 | 83.7 | 1983 | 0.000 | 84 | 118 | 0.271 | 116 |
| Comparative Example 3 | SCASN2 | G-YAG1 | 108.0 | 27.4 | 72.6 | 1995 | 0.000 | 61 | 80 | 0.234 | 100 |

**[Table 5]**

| | Chromaticity coorinates | | Special color rendering index R9 | Radiance ratio Lp(%) 650-750 /400-750 |
|---|---|---|---|---|
| | x | y | | |
| Example 1 | 0.547 | 0.409 | -22 | 22 |
| Exanple 2 | 0.547 | 0.409 | -81 | 17 |
| Example 3 | 0.547 | 0.411 | -133 | 15 |
| Example 4 | 0.546 | 0.409 | 95 | 9 |
| Comparative Example 1 | 0.503 | 0.418 | -36 | 17 |
| Comparative Example 2 | 0.528 | 0.413 | 27 | 31 |
| Comparative Example 3 | 0.527 | 0.413 | -65 | 15 |

**[Table 6]**

| | Phosphor | | | | | Band-pass filter layer | Correlated color temperature CCT (K) | Color deviation Duv | Average color rendering index Ra | Full width at half maximum (nm) of emission peak having maximum emission intensity | Melanopi c ratio MR | Relative Melanopi c Ratio MR/MR₀ (%) | Spectral componen t retention ratio (%) |
|---|---|---|---|---|---|---|---|---|---|---|---|---|---|
| | First Phosphor | Second Phosphor | phosphor total amount (parts by mass) | Blending ratio (mass%) | | | | | | | | | |
| | | | | First phosphor | Second phosphor | | | | | | | | |
| Example 5 | SCASN4 | G-YAG4 | 123.6 | 12.1 | 87.9 | DBR-2 | 1747 | 0.006 | 67 | 88 | 0.129 | 55 | 89.0 |
| Example 6 | SCASN4 | G-YAG4 | 123.6 | 12.1 | 87.9 | DBR-3 | 1767 | 0.006 | 68 | 88 | 0.139 | 60 | 90.2 |
| Example 7 | SCASN1 | YAG3 | 104.3 | 53.3 | 46.7 | DBR-2 | 1758 | 0.007 | 48 | 80 | 0.092 | 40 | 89.1 |
| Example 8 | SCASN1 | YAG3 | 104.3 | 53.3 | 46.7 | DBR-3 | 1767 | 0.007 | 49 | 80 | 0.097 | 41 | 90.2 |
| Example 9 | BSESN2 /BSESN3 = 30/70 | - | 75.0 | 100.0 | - | DBR-2 | 1787 | 0.007 | 28 | 72 | 0.057 | 25 | 89.3 |
| Example 10 | BSESN2 /BSESN3 = 30/70 | - | 75.0 | 100.0 | - | DBR-3 | 1789 | 0.007 | 28 | 72 | 0.058 | 25 | 90.2 |
| Example 11 | KSF | YAG3 | 82.1 | 86.5 | 13.5 | DBR-2 | 1753 | 0.006 | 86 | 4 | 0.162 | 69 | 88.7 |
| Example 12 | KSF | YAG3 | 82.1 | 86.5 | 13.5 | DBR-3 | 1776 | 0.006 | 85 | 4 | 0.172 | 74 | 90.1 |

**[Table 7]**

| | Chromaticity coorinates | | Special color rendering index R9 | Radiance ratio Lp(%) 650-750 /400-750 |
|---|---|---|---|---|
| | x | y | | |
| Example 5 | 0.571 | 0.425 | -30 | 23 |
| Example 6 | 0.569 | 0.426 | -28 | 22 |
| Example 7 | 0.571 | 0.427 | -86 | 18 |
| Example 8 | 0.570 | 0.427 | -85 | 18 |
| Example 9 | 0.569 | 0.430 | -137 | 16 |
| Example 10 | 0.569 | 0.430 | -138 | 16 |
| Example 11 | 0.570 | 0.425 | 89 | 9 |
| Example 12 | 0.568 | 0.427 | 92 | 9 |

As listed in Table 4 and Table 6, the color of the light emitted by the light-emitting devices according to Examples 1 to 12 has a correlated color temperature of 1950 K or less and gives a feeling of warmth close to that of a candle or the flame of an open fire. Even in a case in which the light-emitting device is used instead of a high-pressure sodium lamp, the color of irradiated objects is natural, and the emitted light causes less discomfort to humans. In addition, in the light-emitting devices according to Examples 1 to 12, the full width at half maximum of the emission spectrum indicating the maximum emission intensity was in a range from 3 nm to 110 nm. The emission peak wavelength in the emission spectrum of the light-emitting device was in a range from 570 nm to 680 nm. Because the full width at half maximum of the emission peak having the maximum emission intensity in the emission spectrum of the light-emitting device was in a range from 3 nm to 110 nm, light components on the long wavelength side that are difficult for humans to perceive could be reduced. Also, the light-emitting devices according to Examples 1 to 12 emit light with a melanopic ratio MR derived from Equation (1) of 0.233 or less, and can, without strongly stimulating the ipRGCs of humans, promote melatonin secretion and naturally induce sleep, and thus can conceivably give a feeling of a relaxing atmosphere.

For the light-emitting devices according to Examples 1 to 4, even in a case of emitting light having a color deviation Duv, which is a deviation from the black body radiation locus, of 0.000 and light having a correlated color temperature of 1950 K or less, regarding the light emitted from the light-emitting devices, the color of irradiated objects is natural and the emitted light causes less discomfort to humans.

Even in a case in which the light-emitting devices according to Examples 5 to 12 included a dielectric multilayer film as the band-pass filter layer, the emitted light had a color deviation Duv, which is the deviation from the black body radiation locus, in a range from minus (-) 0.008 to plus (+) 0.008, and thus the color of irradiated objects was natural and the emitted light caused less discomfort to humans.

As listed in Tables 5 and 7, the light-emitting devices according to Examples 1 to 12 each emitted light with the ratio Lp of the second radiance in a range from 650 nm to 750 nm being 30% or less with respect to 100% of the first radiance in a range from 400 nm to 750 nm. Among the mixed color light emitted from the light-emitting devices according to Examples 1 to 12, there is a relatively small amount of light with a red color component on the long wavelength side which are difficult for humans to perceive. Thus, the light emitted from the light-emitting device has warmth and gives a relaxing atmosphere without reduced luminance.

The light-emitting devices according to Examples 1 to 12 have a relative melanopic ratio MR/MR₀ in a range from 40% to 99%, and thus it is thought that the light-emitting device can emit light that, without losing the color balance in the color of the emitted light, promotes melatonin secretion and that naturally induces sleep.

The light-emitting devices according to Examples 1, 2, 4, 5, 6, 7, 8, 11, and 12 emit light with an average color rendering index Ra of 40 or greater and a color rendering property that allows simple tasks to be performed without discomfort even when used in a private space such as a living room, bedroom, or the like, for example.

The light-emitting devices according to Examples 3, 9, and 10 emit light with an average color rendering index Ra in a range from 28 to 40, a color rendering property sufficient for use outdoors such as on the road or the like, and a low melanopic ratio MR of 0.233 or less, giving the light a relaxing atmosphere without strongly stimulating the ipRGCs.

The light-emitting devices according to Examples 5 to 12, even with a dielectric multilayer film provided as the band-pass filter layer, emit light that retains 88% or greater of the emission spectrum of light-emitting devices without a band-pass filter layer, have reduced light on the short wavelength side that tends to stimulate the ipRGCs, and make the irradiated object easy to see by humans.

The light-emitting devices according to Comparative Examples 1 to 3 emit light with a correlated color temperature slightly higher than that of light emitted by a candle or a high-pressure sodium lamp and a melanopic ratio MR of greater than 0.233, and thus it is thought that the emitted light tends to stimulate the ipRGCs and suppress melatonin secretion.

As illustrated in FIGS. 13 to 16, the light-emitting devices according to Examples 1 to 4 emit light with a melanopic ratio MR of 0.233 or less and have a small amount of light components on the short wavelength side that tend to stimulate the ipRGCs, but in a wavelength range from 550 nm to 650 nm which is easily perceived by humans, the emission intensity is greater than that of Comparative Example 3, making irradiated objects easy to see by humans.

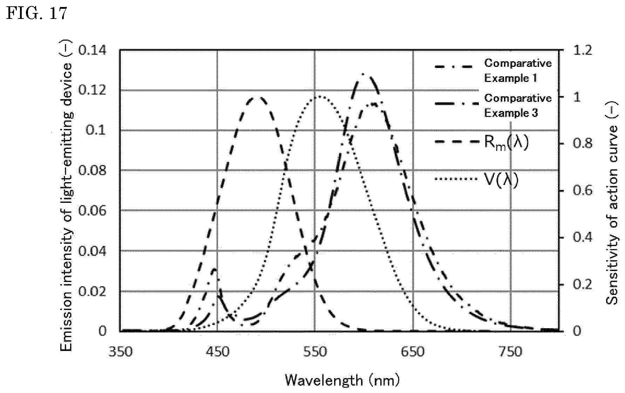

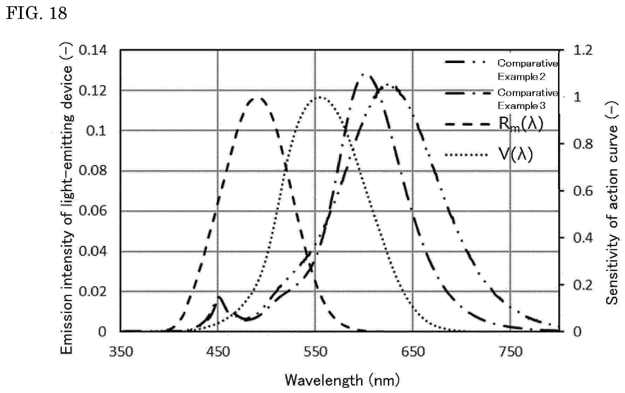

As illustrated in FIGS. 17 and 18, the light-emitting devices according to Comparative Examples 1 to 3 have a melanopic ratio MR of greater than 0.233, and in Comparative Examples 1 and 2, compared to Comparative Example 3 with the lowest melanopic ratio MR from among the comparative examples, the emission intensity on the short wavelength side that tends to stimulate the ipRGCs tends to be higher and melatonin secretion tends to be inhibited.

As illustrated in FIGS. 19 to 22, even though a band-pass filter layer is provided and light emission on the short wavelength side is suppressed, the light-emitting devices according to Examples 5 to 12, emit light with a high emission intensity roughly equal to that of a light-emitting device without a band-pass filter layer and make irradiated objects easy to see for humans.

### Industrial Applicability

A light-emitting device according to an aspect of the present disclosure can be used as general lighting used indoors in a private space such as a living room or bedroom, indirect lighting, or in-vehicle lighting. Other uses include as a light source of a street light, a lighting appliance installed outdoors at a harbor or in a tunnel, or a lighting appliance such as a headlight, flashlight, or portable lantern using LEDs expected to be used outdoors.

### Reference Signs List

1 Support
2 First lead
3 Second lead
4 Conductive member
10 Light-emitting element
21, 22, 26 Wavelength conversion member
23 Phosphor layer
24 Band-pass filter layer
24a First dielectric layer
24b Second dielectric layer
25 Second light-transmissive member
30 First light-transmissive member
32 Light transmissive bonding member
41 Molded body
42 Resin portion
43 Light reflecting member
50 Encapsulation member
51 Lens portion
52 Flange portion
60 Wire
70 Phosphor
71 First phosphor
72 Second phosphor
100, 200, 300, 400 Light-emitting device
1000 Street light
1001 Low-position lighting device
B Placement platform
C1, C2 Roadway
Le Light source
P Pole
S Support portion
T Light transmitting portion
W Sidewalk

## Claims

1. A light-emitting device comprising:
a light-emitting element having an emission peak wavelength in a range of 400 nm to 490 nm; and
a first phosphor having an emission peak wavelength in a range of 570 nm to 680 nm, and a second phosphor having an emission peak wavelength in a range of 480 nm to less than 570 nm, wherein
the light-emitting device emits light having a correlated color temperature that is 1950 K or less, an average color rendering index Ra that is 40 or greater, a full width at half maximum of an emission spectrum indicating a maximum emission intensity in an emission spectrum that is the light-emitting device of 110 nm or less, and a melanopic ratio MR derived from Equation (1) that is 0.233 or less, $Melanopic ratio MR = \frac{{\int }_{380}^{730} S \left(λ\right) \times {R}_{m} \left(λ\right) dλ}{{\int }_{380}^{730} S \left(λ\right) \times V \left(λ\right) dλ} \times 1.218$ (1)
wherein, S(λ) is a spectral radiance of the light emitted by the light-emitting device, V(λ) is a luminous efficiency function for human photopic vision specified by Commission Internationale de l'Eclairage (CIE), and Rₘ(λ) is a sensitivity function of intrinsically photosensitive Retinal Ganglion Cells (ipRGC) for mammals specified by Commission Internationale de l'Eclairage (CIE),
wherein
the first phosphor includes at least one selected from the group consisting of a first nitride phosphor having a composition represented by Formula (1A), a second nitride phosphor having a composition represented by Formula (1B), a first fluoride phosphor having a composition represented by Formula (1C), and a second fluoride phosphor having a composition represented by Formula (1C") different from the composition represented by Formula (1C),
M¹₂Si₅N₈:Eu (1A)
where M¹ is an alkaline earth metal element including at least one selected from the group consisting of Ca, Sr, and Ba,
Sr_{q}CaₛAlₜSiᵤNᵥ:Eu (1B)
where q, s, t, u, and v satisfy 0 ≤ q < 1, 0 < s ≤ 1, q + s ≤ 1, 0.9 ≤ t ≤ 1.1, 0.9 ≤ u ≤ 1.1, and 2.5 ≤ v ≤ 3.5,
A_{c}[M²_{1-b}Mn⁴⁺_{b}F_{d}] (1C)
wherein A includes at least one selected from the group consisting of K⁺, Li⁺, Na⁺, Rb⁺, Cs⁺, and NH₄⁺, M² includes at least one element selected from the group consisting of Group 4 elements and Group 14 elements, b satisfies 0 < b < 0.2, c is an absolute value of electric charge of [M²_{1-b}Mn⁴⁺₆F_{d}] ion, and d satisfies 5 < d < 7,
A'_{c'}[M^{2'}_{1-b'}Mn⁴⁺_{b'}F_{d'}] (1C')
wherein A' includes at least one selected from the group consisting of K⁺, Li⁺, Na⁺, Rb⁺, Cs⁺, and NH₄⁺, M²' includes at least one element selected from the group consisting of Group 4 elements, Group 13 elements, and Group 14 elements, b' satisfies 0 < b' < 0.2, c' is an absolute value of electric charge of [M^{2'}_{1-b},Mn⁴⁺_{b'}F_{d'}] ion, and d' satisfies 5 < d' < 7,
the second phosphor includes at least one selected from the group consisting of a rare earth aluminate phosphor having a composition represented by Formula (2A) and a third nitride phosphor having the composition represented by Formula (2B),
Ln¹₃(Al₁₋ₐGaₐ)₅O₁₂:Ce (2A)
wherein Ln¹ is at least one element selected from the group consisting of Y, Gd, Tb, and Lu, and a satisfies 0 ≤ a ≤ 0.5,
La_{w}Ln²ₓSi₆N_{y}:Ce_{z} (2B)
wherein, Ln² includes at least one selected from the group consisting of Y and Gd and includes at least one selected from the group consisting of Sc and Lu, and, if the Ln² element included in 1 mol of the composition is 100 mol%, the total of Y and Gd included in Ln² is 90 mol% or greater, and w, x, y, and z satisfy 1.2 ≤ w ≤ 2.2, 0.5 ≤ x ≤ 1.2, 10 ≤ y ≤ 12.0, 0.5 ≤ z ≤ 1.2, 1.80 < w + x < 2.40, and 2.9 ≤ w + x + z ≤ 3.1, and a relative melanopic ratio MR/MR₀ is in a range from 10% to 99%, wherein the .relative melanopic ratio MR/MR₀ is a ratio of the melanopic ratio MR derived from the Equation (1) of the light-emitting device emitting light having a correlated color temperature of 1950 K or less assuming a reference melanopic ratio MR derived from following an Equation (4) of the light-emitting device emitting light having a correlated color temperature of greater than 1950 K is 100%, $Melanopic ratio {MR}_{0} = \frac{{\int }_{380}^{730} {S}_{0} \left(λ\right) \times {R}_{m} \left(λ\right) dλ}{{\int }_{380}^{730} {S}_{0} \left(λ\right) \times V \left(λ\right) dλ} \times 1.218$ (4)
wherein, MR0 is a melanopic ratio of a light-emitting device having a correlated color temperature of greater than 1950 K, S0(λ) is a spectral radiance of light emitted by the light-emitting device having a correlated color temperature of greater than 1950 K, S(λ) is a spectral radiance of the light emitted by the light-emitting device, V(λ) is a luminous efficiency function for human photopic vision specified by Commission Internationale de l'Eclairage (CIE).

2. The light-emitting device according to claim 1, wherein
the first phosphor further includes at least one selected from the group consisting of a second nitride phosphor having a composition represented by Formula (1B), a first fluoride phosphor having a composition represented by Formula (1C), and a second fluoride phosphor having a composition represented by Formula (1C') different from the composition represented by Formula (1C),
Sr_{q}CaₛAlₜSiᵤNᵥ:Eu (1B)
where q, s, t, u, and v satisfy 0 ≤ q < 1, 0 < s ≤ 1, q + s ≤ 1, 0.9 ≤ t ≤ 1.1, 0.9 ≤ u ≤ 1.1, and 2.5 ≤ v ≤ 3.5,
A_{c}[M²_{1-b}Mn⁴⁺_{b}F_{d}] (1C)
wherein A includes at least one selected from the group consisting of K⁺, Li⁺, Na⁺, Rb⁺, Cs⁺, and NH₄⁺, M² includes at least one element selected from the group consisting of Group 4 elements and Group 14 elements, b satisfies 0 < b < 0.2, c is an absolute value of electric charge of [M²_{1-b}Mn⁴⁺_{b}F_{d}] ion, and d satisfies 5 < d < 7,
A'_{c'}[M^{2'}_{1-b'}Mn⁴⁺_{b'}F_{d'}] (1C')
wherein A' includes at least one selected from the group consisting of K⁺, Li⁺, Na⁺, Rb⁺, Cs⁺, and NH₄⁺, M²' includes at least one element selected from the group consisting of Group 4 elements, Group 13 elements, and Group 14 elements, b' satisfies 0 < b' < 0.2, c' is an absolute value of electric charge of [M^{2'}_{1-b'}Mn⁴⁺_{b'}F_{d'}] ion, and d' satisfies 5 < d' < 7.

3. The light-emitting device according to any one of claims 1 or 2, wherein
the first phosphor has a full width at half maximum of an emission spectrum indicating a maximum emission intensity in an emission spectrum of the first phosphor in a range of 3 nm to 120 nm.

4. The light-emitting device according to any one of claims 1 to 3, wherein
the second phosphor has a full width at half maximum of an emission spectrum indicating a maximum emission intensity in an emission spectrum of the second phosphor in a range of 20 nm to 125 nm.

5. The light-emitting device according to any one of claims 1 to 4, wherein
a content of the first phosphor relative to a total amount of the first phosphor and the second phosphor is in a range of 5 mass% to 95 mass%.

6. The light-emitting device according to any one of claims 1 to 5, wherein the light emitted by the light-emitting device has a color deviation Duv from a black body radiation locus in a range of -0.008 to +0.008.

7. The light-emitting device according to any one of claims 1 to 6, wherein the light emitted by the light-emitting device has a second radiance in a range of 650 nm to 750 nm being 50% or less relative to 100% of a first radiance in a range of 400 nm to 750 nm.

8. The light-emitting device according to any one of claims 1 to 7, wherein
on a light emission side of the light-emitting element, a wavelength conversion member including a phosphor layer including the first phosphor and a band-pass filter layer disposed on a light emission side of the phosphor layer is provided, and
the band-pass filter layer has an average reflectivity of light within a wavelength range of 380 nm to less than 495 nm that is 80% or greater and has an average reflectivity of light within a wavelength range of greater than 580 nm to 780 nm that is 20% or less, with respect to light with an angle of incidence in a range of 0 degrees to 30 degrees.

9. A lighting appliance comprising:
the light-emitting device described in any one of claims 1 to 8.

10. A lighting fixture comprising:
the light-emitting device described in any one of claims 1 to 8.

## Patentansprüche

1. Lichtemittierende Vorrichtung, aufweisend:
ein lichtemittierendes Element, das eine Emissionspeakwellenlänge in einem Bereich von 400 nm bis 490 nm hat; und
einen ersten Leuchtstoff, der eine Emissionspeakwellenlänge in einem Bereich von 570 nm bis 680 nm hat, und einen zweiten Leuchtstoff, der eine Emissionspeakwellenlänge in einem Bereich von 480 nm bis weniger als 570 nm hat, wobei
die lichtemittierende Vorrichtung Licht emittiert, das eine korrelierte Farbtemperatur, die 1950 K oder weniger beträgt, einen durchschnittlichen Farbwiedergabeindex Ra, der 40 oder mehr beträgt, eine Halbwertsbreite eines Emissionsspektrums, das eine maximale Emissionsintensität in einem Emissionsspektrum anzeigt, das die lichtemittierende Vorrichtung ist, von 110 nm oder weniger und ein aus Gleichung (1) abgeleitetes melanopisches Verhältnis MR, das 0,233 oder weniger beträgt, hat, $Melanopisches Verhältnis MR = \frac{{\int }_{380}^{730} S \left(λ\right) \times {R}_{m} \left(λ\right) dλ}{{\int }_{380}^{730} S \left(λ\right) \times V \left(λ\right) dλ} \times 1 , 218$ (1)
wobei S(λ) eine spektrale Strahldichte des Lichts, das durch die lichtemittierende Vorrichtung emittiert wird, ist, V(λ) eine Hellempfindlichkeitskurve für das menschliche photopische Sehen, die durch die Commission Internationale de l'Eclairage (CIE) spezifiziert ist, ist, und Rₘ(λ) eine Empfindlichkeitsfunktion für intrinsisch photosensitive retinale Ganglienzellen (ipRGC) für Säugetiere, die durch die Commission Internationale de l'Eclairage (CIE) spezifiziert ist, ist,
wobei
der erste Leuchtstoff mindestens eines einschließt, ausgewählt aus der Gruppe bestehend aus einem ersten Nitrid-Leuchtstoff, der eine Zusammensetzung, die durch Formel (1A) dargestellt wird, hat, einem zweiten Nitrid-Leuchtstoff, der eine Zusammensetzung, die durch Formel (1B) dargestellt wird, hat, einem ersten Fluorid-Leuchtstoff, der eine Zusammensetzung, die durch Formel (1C) dargestellt wird, hat, und einem zweiten Fluorid-Leuchtstoff, der eine Zusammensetzung, die durch Formel (1C') dargestellt wird, hat, die sich von der Zusammensetzung, die durch Formel (1C) dargestellt wird, unterscheidet,
M¹₂Si₅N₈:Eu (1A)
wobei M¹ ein Erdalkalimetallelement ist, das mindestens eines einschließt, ausgewählt aus der Gruppe bestehend aus Ca, Sr und Ba,
Sr_{q}CaₛAlₜSiᵤNᵥ:Eu (1B)
wobei q, s, t, u und v 0 ≤ q < 1, 0 < s ≤ 1, q + s ≤ 1, 0,9 ≤ t ≤ 1,1, 0,9 ≤ u ≤ 1,1 und 2,5 ≤ v ≤ 3,5 erfüllen,
A_{c}[M²_{1-b}Mn⁴⁺_{b}F_{d}] (1C)
wobei A mindestens eines einschließt, ausgewählt aus der Gruppe bestehend aus K⁺, Li⁺, Na⁺, Rb⁺, Cs⁺ und NH₄⁺, M² mindestens ein Element einschließt, ausgewählt aus der Gruppe bestehend aus Elementen der Gruppe 4 und Elementen der Gruppe 14, b 0 < b < 0,2 erfüllt, c ein absoluter Wert der elektrischen Ladung des [M²_{1-b}Mn⁴⁺_{b}F_{d}]-Ions ist, und d 5 < d < 7 erfüllt,
A'_{c'}[M^{2'}_{1-b'}Mn⁴⁺_{b'}F_{d'}] (1C')
wobei A' mindestens eines einschließt, ausgewählt aus der Gruppe, bestehend aus K⁺, Li⁺, Na⁺, Rb⁺, Cs⁺ und NH₄⁺, M^{2'} mindestens ein Element einschließt, ausgewählt aus der Gruppe, bestehend aus Elementen der Gruppe 4, Elementen der Gruppe 13 und Elementen der Gruppe 14, b' 0 < b' < 0,2 erfüllt, c' ein absoluter Wert der elektrischen Ladung des [M^{2'}_{1 -b'}Mn⁴⁺_{b'}F_{d'}]-Ions ist und d' 5 < d' < 7 erfüllt,
der zweite Leuchtstoff mindestens eines einschließt, ausgewählt aus der Gruppe bestehend aus einem Seltenerdaluminat-Leuchtstoff, der eine Zusammensetzung, die durch Formel (2A) dargestellt wird, hat und einem dritten Nitrid-Leuchtstoff, der die Zusammensetzung, die durch Formel (2B) dargestellt wird, hat,
Ln¹₃(Al₁₋ₐGaₐ)₅O₁₂:Ce (2A)
wobei Ln¹ mindestens ein Element ist, ausgewählt aus der Gruppe bestehend aus Y, Gd, Tb und Lu, und a 0 ≤ a ≤ 0,5 erfüllt,
La_{w}Ln ²ₓSi₆N_{y}:Ce_{z} (2B)
wobei Ln² mindestens eines einschließt, ausgewählt aus der Gruppe bestehend aus Y und Gd und mindestens eines einschließt, ausgewählt aus der Gruppe bestehend aus Sc und Lu, und, falls das Ln²-Element, das in 1 mol der Zusammensetzung eingeschlossen ist, 100 mol% beträgt, die Gesamtmenge an Y und Gd, das in Ln² eingeschlossen ist, 90 mol% oder mehr beträgt, und w, x, y und z 1,2 ≤ w ≤ 2,2, 0,5 ≤ x ≤ 1,2, 10 ≤ y ≤ 12,0, 0,5 ≤ z ≤ 1,2, 1,80 < w + x < 2,40 und 2,9 ≤ w + x + z ≤ 3,1 erfüllen, und ein relatives melanopisches Verhältnis MR/MR₀ in einem Bereich von 10 % bis 99 % liegt, wobei das relative melanopische Verhältnis MR/MR₀ ein Verhältnis des melanopischen Verhältnisses MR, das aus der Gleichung (1) der lichtemittierenden Vorrichtung abgeleitet ist, die Licht emittiert, das eine korrelierte Farbtemperatur von 1950 K oder weniger hat, ist, unter der Annahme, dass ein melanopisches Referenzverhältnis MR aus einer folgenden Gleichung (4) der lichtemittierenden Vorrichtung abgeleitet ist, die Licht emittiert, das eine korrelierte Farbtemperatur von mehr als 1950 K hat, 100 % beträgt, $Melanopisches Verhältnis {MR}_{0} = \frac{{\int }_{380}^{730} {S}_{0} \left(λ\right) \times {R}_{m} \left(λ\right) dλ}{{\int }_{380}^{730} {S}_{0} \left(λ\right) \times V \left(λ\right) dλ} \times 1 , 218$ (4)
wobei MR0 ein melanopisches Verhältnis einer lichtemittierenden Vorrichtung, die eine korrelierte Farbtemperatur von mehr als 1950 K hat, ist, S0(λ) eine spektrale Strahldichte von Licht ist, das durch die lichtemittierende Vorrichtung, die eine korrelierte Farbtemperatur von mehr als 1950 K hat, emittiert wird, S(λ) eine spektrale Strahldichte des Lichts, das durch die lichtemittierende Vorrichtung emittiert wird, ist, V(λ) eine Hellempfindlichkeitskurve für das menschliche photopische Sehen, die durch die Commission Internationale de l'Eclairage (CIE) spezifiziert ist, ist.

2. Lichtemittierende Vorrichtung nach Anspruch 1, wobei
der erste Leuchtstoff ferner mindestens eines einschließt, ausgewählt aus der Gruppe bestehend aus einem zweiten Nitrid-Leuchtstoff, der eine Zusammensetzung, die durch Formel (1B) dargestellt wird, hat, einem ersten Fluorid-Leuchtstoff, der eine Zusammensetzung, die durch Formel (1C) dargestellt wird, hat, und einem zweiten Fluorid-Leuchtstoff, der eine Zusammensetzung, die durch Formel (1C') dargestellt wird, hat, die sich von der Zusammensetzung, die durch Formel (1C) dargestellt wird, unterscheidet,
Sr_{q}CaₛAlₜSiᵤNᵥ:Eu (1B)
wobei q, s, t, u und v 0 ≤ q < 1, 0 < s ≤ 1, q + s ≤ 1, 0,9 ≤ t ≤ 1,1, 0,9 ≤ u ≤ 1,1 und 2,5 ≤ v ≤ 3,5 erfüllen,
A_{c}[M²_{1-b}Mn⁴⁺_{b}F_{d}] (1C)
wobei A mindestens eines einschließt, ausgewählt aus der Gruppe bestehend aus K⁺, Li⁺, Na⁺, Rb⁺, Cs⁺ und NH₄⁺, M² mindestens ein Element einschließt, ausgewählt aus der Gruppe bestehend aus Elementen der Gruppe 4 und Elementen der Gruppe 14, b 0 < b < 0,2 erfüllt, c ein absoluter Wert der elektrischen Ladung des [M²_{1-b}Mn⁴⁺_{b}F_{d}]-Ions ist, und d 5 < d < 7 erfüllt,
A'_{c'}[M²'_{1-b'}Mn⁴⁺_{b'}F_{d'}] (1C')
wobei A' mindestens eines einschließt, ausgewählt aus der Gruppe, bestehend aus K⁺, Li⁺, Na⁺, Rb⁺, Cs⁺ und NH₄⁺, M^{2'} mindestens ein Element einschließt, ausgewählt aus der Gruppe, bestehend aus Elementen der Gruppe 4, Elementen der Gruppe 13 und Elementen der Gruppe 14, b' 0 < b' < 0,2 erfüllt, c' ein absoluter Wert der elektrischen Ladung des [M^{2'}_{1-b'}Mn⁴⁺_{b'}F_{d'}]-Ions ist und d' 5 < d' < 7 erfüllt.

3. Lichtemittierende Vorrichtung nach einem der Ansprüche 1 oder 2, wobei
der erste Leuchtstoff eine Halbwertsbreite eines Emissionsspektrums, das eine maximale Emissionsintensität in einem Emissionsspektrum des ersten Leuchtstoffs anzeigt, in einem Bereich von 3 nm bis 120 nm hat.

4. Lichtemittierende Vorrichtung nach einem der Ansprüche 1 bis 3, wobei
der zweite Leuchtstoff eine Halbwertsbreite eines Emissionsspektrums, das eine maximale Emissionsintensität in einem Emissionsspektrum des zweiten Leuchtstoffs anzeigt, in einem Bereich von 20 nm bis 125 nm hat.

5. Lichtemittierende Vorrichtung nach einem der Ansprüche 1 bis 4, wobei
ein Gehalt des ersten Leuchtstoffs bezogen auf eine Gesamtmenge des ersten Leuchtstoffs und des zweiten Leuchtstoffs in einem Bereich von 5 Masse-% bis 95 Masse-% liegt.

6. Lichtemittierende Vorrichtung nach einem der Ansprüche 1 bis 5, wobei das Licht, das durch die lichtemittierende Vorrichtung emittiert wird, eine Farbabweichung Duv von einem Schwarzkörperstrahlungsort in einem Bereich von -0,008 bis +0,008 hat.

7. Lichtemittierende Vorrichtung nach einem der Ansprüche 1 bis 6, wobei das Licht, das durch die lichtemittierende Vorrichtung emittiert wird, eine zweite Strahldichte in einem Bereich von 650 nm bis 750 nm hat, die 50 % oder weniger bezogen auf 100 % einer ersten Strahldichte in einem Bereich von 400 nm bis 750 nm beträgt.

8. Lichtemittierende Vorrichtung nach einem der Ansprüche 1 bis 7, wobei
auf einer Lichtemissionsseite des lichtemittierenden Elements ein Wellenlängenumwandlungsteil, das eine Leuchtstoffschicht einschließt, die den ersten Leuchtstoff und eine Bandpassfilterschicht einschließt, die auf einer Lichtemissionsseite der Leuchtstoffschicht angeordnet ist, bereitgestellt ist, und
die Bandpassfilterschicht ein durchschnittliches Reflexionsvermögen von Licht innerhalb eines Wellenlängenbereichs von 380 nm bis weniger als 495 nm, das 80 % oder mehr beträgt, hat, und ein durchschnittliches Reflexionsvermögen von Licht innerhalb eines Wellenlängenbereichs von mehr als 580 nm bis 780 nm, das 20 % oder weniger beträgt, in Bezug auf Licht mit einem Einfallswinkel in einem Bereich von 0 Grad bis 30 Grad hat.

9. Beleuchtungseinrichtung, aufweisend:
die lichtemittierende Vorrichtung nach einem der Ansprüche 1 bis 8.

10. Beleuchtungskörper, aufweisend:
die lichtemittierende Vorrichtung nach einem der Ansprüche 1 bis 8.

## Revendications

1. Dispositif électroluminescent comprenant :
un élément électroluminescent ayant une longueur d'onde de pic d'émission dans une plage de 400 nm à 490 nm ; et
un premier luminophore ayant une longueur d'onde de pic d'émission dans une plage de 570 nm à 680 nm, et un second luminophore ayant une longueur d'onde de pic d'émission dans une plage de 480 nm à moins de 570 nm, dans lequel
le dispositif électroluminescent émet une lumière ayant une température de couleur corrélée qui est égale ou inférieure à 1 950 K, un indice de rendu des couleurs moyen Ra qui est égal ou supérieur à 40, une largeur à mi-hauteur d'un spectre d'émission indiquant une intensité d'émission maximale dans un spectre d'émission qui est le dispositif électroluminescent égal ou inférieur à 110 nm, et un rapport mélanopique MR dérivé de l'équation (1) qui est égal ou inférieur à 0,233, $Rapport mélanopique MR = \frac{{\int }_{380}^{730} S \left(λ\right) \times {R}_{m} \left(λ\right) dλ}{{\int }_{380}^{730} S \left(λ\right) \times V \left(λ\right) dλ} \times 1 , 218$ (1)
où, S(λ) est une luminance spectrale de la lumière émise par le dispositif électroluminescent, V(λ) est une fonction d'efficacité lumineuse pour la vision photopique humaine spécifiée par la Commission internationale de l'éclairage (CIE), et Rₘ(λ) est une fonction de sensibilité de cellules ganglionnaires de la rétine intrinsèquement photosensibles (ipRGC) pour les mammifères spécifiée par la Commission internationale de l'éclairage (CIE),
dans lequel
le premier luminophore comporte au moins un élément choisi dans le groupe constitué d'un premier luminophore de nitrure ayant une composition représentée par la formule (1A), un deuxième luminophore de nitrure ayant une composition représentée par la formule (1B), un premier luminophore de fluorure ayant une composition représentée par la formule (1C), et un second luminophore de fluorure ayant une composition représentée par la formule (1C') différente de la composition représentée par la formule (1C),
M¹₂Si₅N₈:Eu (1A)
où M¹ est un élément de métal alcalino-terreux comportant au moins un élément choisi dans le groupe constitué de Ca, Sr et Ba,
Sr_{q}CaₛAlₜSiᵤNᵥ:Eu (1B)
où q, s, t, u et v satisfont à 0 ≤ q < 1, 0 < s ≤ 1, q + s ≤ 1, 0,9 ≤ t ≤ 1,1, 0,9 ≤ u ≤ 1,1 et 2,5 ≤ v ≤ 3,5,
A_{c}[M²_{1-b}Mn⁴⁺_{b}F_{d}] (1C)
où A comporte au moins un élément choisi dans le groupe constitué de K⁺, Li⁺, Na⁺, Rb⁺, Cs⁺ et NH₄⁺, M² comporte au moins un élément choisi dans le groupe constitué d'éléments du groupe 4 et d'éléments du groupe 14, b satisfait à 0 < b < 0,2, c est une valeur absolue de charge électrique de l'ion [M²_{1-b}Mn⁴⁺_{b}F_{d}], et d satisfait à 5 < d < 7,
A'_{c'}[M^{2'}_{1-b'}Mn⁴⁺_{b'}F_{d'}] (1C')
où A' comporte au moins un élément choisi dans le groupe constitué de K⁺, Li⁺, Na⁺, Rb⁺, Cs⁺ et NH₄⁺, M^{2'} comporte au moins un élément choisi dans le groupe constitué d'éléments du groupe 4, d'éléments du groupe 13 et d'éléments du groupe 14, b' satisfait à 0 < b' < 0,2, c' est une valeur absolue de charge électrique de l'ion [M^{2'}_{1-b'}Mn⁴⁺_{b'}F_{d'}], et d' satisfait à 5 < d' < 7,
le second luminophore comporte au moins un élément choisi dans le groupe constitué d'un luminophore d'aluminate de terre rare ayant une composition représentée par la Formule (2A) et un troisième luminophore de nitrure ayant la composition représentée par la Formule (2B),
Ln¹₃(Al₁₋ₐGaₐ)₅O₁₂:Ce (2A)
où Ln¹ est au moins un élément choisi dans le groupe constitué de Y, Gd, Tb et Lu, et a satisfait à 0 ≤ a ≤ 0,5,
La_{w}Ln²ₓSi₆N_{y}:Ce_{z} (2B)
où, Ln² comporte au moins un élément choisi dans le groupe constitué de Y et Gd et comporte au moins un élément choisi dans le groupe constitué de Sc et Lu, et, si l'élément Ln² inclus dans 1 mole de la composition est de 100 % en moles, le total de Y et Gd inclus dans Ln² est égal ou supérieur à 90 % en moles, et w, x, y et z satisfont à 1,2 ≤ w ≤ 2,2, 0,5 ≤ x ≤ 1,2, 10 ≤ y ≤ 12,0, 0,5 ≤ z ≤ 1,2, 1,80 < w + x < 2,40, et 2,9 ≤ w + x + z ≤ 3,1, et un rapport mélanopique relatif MR/MR₀ est dans une plage de 10 % à 99 %, dans lequel le rapport mélanopique relatif MR/MR₀ est un rapport du rapport mélanopique MR dérivé de l'équation (1) du dispositif électroluminescent émettant de la lumière ayant une température de couleur corrélée égale ou inférieure à 1 950 K en supposant un rapport mélanopique MR de référence dérivé du suivi d'une équation (4) du dispositif électroluminescent émettant de la lumière ayant une température de couleur corrélée supérieure à 1 950 K est de 100 %, $Rapport mélanopique {MR}_{0} = \frac{{\int }_{380}^{730} {S}_{0} \left(λ\right) \times {R}_{m} \left(λ\right) dλ}{{\int }_{380}^{730} {S}_{0} \left(λ\right) \times V \left(λ\right) dλ} \times 1 , 218$ (4)
où, MR₀ est un rapport mélanopique d'un dispositif électroluminescent ayant une température de couleur corrélée supérieure à 1 950 K, S0(λ) est une luminance spectrale de la lumière émise par le dispositif électroluminescent ayant une température de couleur corrélée supérieure à 1 950 K, S(λ) est une luminance spectrale de la lumière émise par le dispositif électroluminescent, V(λ) est une fonction d'efficacité lumineuse pour la vision photopique humaine spécifiée par la Commission internationale de l'éclairage (CIE).

2. Dispositif électroluminescent selon la revendication 1, dans lequel
le premier luminophore comporte en outre au moins un élément choisi dans le groupe constitué d'un deuxième luminophore de nitrure ayant une composition représentée par la formule (1B), un premier luminophore de fluorure ayant une composition représentée par la formule (1C), et un second luminophore de fluorure ayant une composition représentée par la formule (1C') différente de la composition représentée par la formule (1C),
Sr_{q}CaₛAlₜSiᵤNᵥ:Eu (1B)
où q, s, t, u et v satisfont à 0 ≤ q < 1, 0 < s ≤ 1, q + s ≤ 1, 0,9 ≤ t ≤ 1,1, 0,9 ≤ u ≤ 1,1 et 2,5 ≤ v ≤ 3,5,
A_{c}[M²_{1-b}Mn⁴⁺_{b}F_{d}] (1C)
où A comporte au moins un élément choisi dans le groupe constitué de K⁺, Li⁺, Na⁺, Rb⁺, Cs⁺ et NH₄⁺, M² comporte au moins un élément choisi dans le groupe constitué d'éléments du groupe 4 et d'éléments du groupe 14, b satisfait à 0 < b < 0,2, c est une valeur absolue de charge électrique de l'ion [M²_{1-b}Mn⁴⁺_{b}F_{d}], et d satisfait à 5 < d < 7,
A'_{c'}[M²'_{1-b'}Mn⁴⁺_{b'}F_{d'}] (1C')
où A' comporte au moins un élément choisi dans le groupe constitué de K⁺, Li⁺, Na⁺, Rb⁺, Cs⁺ et NH₄⁺, M²' comporte au moins un élément choisi dans le groupe constitué d'éléments du groupe 4, d'éléments du groupe 13 et d'éléments du groupe 14, b' satisfait à 0 < b' < 0,2, c' est une valeur absolue de charge électrique de l'ion [M^{2'}_{1-b'}Mn⁴⁺_{b'}F_{d'}], et d' satisfait à 5 < d' < 7.

3. Dispositif électroluminescent selon l'une quelconque des revendications 1 ou 2, dans lequel
le premier luminophore a une largeur à mi-hauteur d'un spectre d'émission indiquant une intensité d'émission maximale dans un spectre d'émission du premier luminophore dans une plage de 3 nm à 120 nm.

4. Dispositif électroluminescent selon l'une quelconque des revendications 1 à 3, dans lequel
le second luminophore a une largeur à mi-hauteur d'un spectre d'émission indiquant une intensité d'émission maximale dans un spectre d'émission du second luminophore dans une plage de 20 nm à 125 nm.

5. Dispositif électroluminescent selon l'une quelconque des revendications 1 à 4, dans lequel
une teneur du premier luminophore par rapport à une quantité totale du premier luminophore et du second luminophore est dans une plage de 5 % en masse à 95 % en masse.

6. Dispositif électroluminescent selon l'une quelconque des revendications 1 à 5, dans lequel la lumière émise par le dispositif électroluminescent a un écart de couleur Duv par rapport à un lieu de rayonnement de corps noir dans une plage de -0,008 à +0,008.

7. Dispositif électroluminescent selon l'une quelconque des revendications 1 à 6, dans lequel la lumière émise par le dispositif électroluminescent a une seconde luminance dans une plage de 650 nm à 750 nm étant égale ou inférieure à 50 % par rapport à 100 % d'une première luminance dans une plage de 400 nm à 750 nm.

8. Dispositif électroluminescent selon l'une quelconque des revendications 1 à 7, dans lequel
sur un côté d'émission de lumière de l'élément électroluminescent, un organe de conversion de longueur d'onde comportant une couche de luminophore comportant le premier luminophore et une couche de filtre passe-bande disposée sur un côté d'émission de lumière de la couche de luminophore est prévu, et
la couche de filtre passe-bande a une réflectivité moyenne de la lumière dans une plage de longueurs d'onde de 380 nm à moins de 495 nm qui est égale ou supérieure à 80 % et a une réflectivité moyenne de la lumière dans une plage de longueurs d'onde de plus de 580 nm à 780 nm qui est égale ou inférieure à 20 %, par rapport à une lumière avec un angle d'incidence dans une plage de 0 degré à 30 degrés.

9. Appareil d'éclairage comprenant :
le dispositif électroluminescent décrit dans l'une quelconque des revendications 1 à 8.

10. Luminaire comprenant :
le dispositif électroluminescent décrit dans l'une quelconque des revendications 1 à 8.
